# EUROPEAN PATENT APPLICATION

(11) **EP 4 704 521 A1**
(43) Date of publication of application: **04.03.2026**
(21) Application number: 25197151.1
(22) Date of filing: 20.08.2025
(51) Int. Cl.: H10F 19/40, H10F 19/90, H10K 39/12, H10K 85/50

(54) **PHOTOVOLTAIC CELL ASSEMBLIES FOR POWER GENERATION PARAMETER MATCHING**

(30) Priority: 26.08.2024 US 202418815813; 26.08.2024 US 202418815826
(71) Applicant: Tandem PV, San Jose, CA 95131 (US)
(72) Inventor: BAILIE, Colin David, Morgan Hill, 95037 (US); EBERSPACHER, Chris, Palo Alto, 94306 (US)
(74) Representative: Forresters IP LLP

(57) **Abstract**

A photovoltaic device includes a first photovoltaic cell assembly and a second photovoltaic cell assembly. The first photovoltaic cell assembly includes a first group of thin-film photovoltaic cells electrically connected in series and a second group of photovoltaic cells electrically connected in series. The second photovoltaic cell assembly includes a third group of thin-film photovoltaic cells electrically connected in series and a fourth group of photovoltaic cells electrically connected in series. The first group and the third group have a common electrode. An electrical connection of the first photovoltaic cell assembly and the second photovoltaic cell assembly is configured to match a voltage at maximum power (Vmp) generated by the first group and the third group and by the second group and the fourth group.

## Description

### BACKGROUND

### Field

Embodiments of the present invention generally relate to photovoltaic modules and methods for power generation parameter matching.

### Description of the Related Art

Tandem photovoltaic modules that include thin-film photovoltaic cells stacked with other types of photovoltaic cells formed from another material such as silicon are attractive options for electric power generation because the combination of materials in these configurations is capable of more efficiently generating power form a broad spectrum of electromagnetic radiation compared to traditional solar cells. However, the different power generation characteristics of the thin-film photovoltaic cells and the silicon (or another material) photovoltaic cells present challenges to electric power generation. For example, the thin-film and the silicon containing cells reach peak efficiencies at significantly different electromagnetic radiation intensities, and the power generation characteristics of the two materials change differently in response to temperature changes.

Therefore there is a need for an apparatus and method of using tandem photovoltaic modules for power generation that solve the problems described above.

### SUMMARY

Embodiments of the disclosure describe a photovoltaic device assembly including a first electrode, a second electrode, and a third electrode. The photovoltaic device assembly also includes a first plurality of photovoltaic cells and a second plurality of photovoltaic cells. Each photovoltaic cell of the first plurality of photovoltaic cells is serially electrically connected in a first direction between the first electrode and the second electrode. Each photovoltaic cell of the second plurality of photovoltaic cells is serially electrically connected in a second direction between the first electrode and the third electrode and the second direction is opposite to the first direction.

In some embodiments of the photovoltaic device assembly, the first plurality of photovoltaic cells each comprise a portion of a first contact layer, a portion of a second contact layer, and a portion of an absorber layer disposed between the portion of the contact layer and the portion of the second contact layer. In one or more embodiments, the second plurality of photovoltaic cells each comprise a portion of the first contact layer, a portion of the second contact layer, and a portion of the absorber layer disposed between the portion of first contact layer and the portion of the second contact layer. In some embodiments, the first electrode includes a flat ribbon that is disposed on a portion of the first contact layer of the first plurality of photovoltaic cells and a portion of the first contact layer of the second plurality of photovoltaic cells.

Embodiments of the disclosure describe a photovoltaic device assembly including a first plurality of photovoltaic cells and a second plurality of photovoltaic cells. Each photovoltaic cell of the first plurality of photovoltaic cells is connected in series between a first end and a second end of the first plurality of photovoltaic cells. At least one photovoltaic cell of the first plurality of photovoltaic cells includes a first portion of a first contact layer disposed over a surface of a substrate, a first portion of an absorber layer disposed over the first portion of the first contact layer, and a first portion of a second contact layer disposed over the first portion of the absorber layer. The first portion of the first contact layer is disposed between two first P1 scribe lines. A first P2 scribe line is formed through the first portion of the absorber layer. A first P3 scribe line extends through the first portion of the second contact layer and the first portion of the absorber layer. The two first P1 scribe lines, the first P2 scribe line, and the first P3 scribe line are serially positioned in a first direction that is parallel to the surface of the substrate. Each photovoltaic cell of the second plurality of photovoltaic cells is connected in series between a first end and a second end of the second plurality of photovoltaic cells. At least one photovoltaic cell of the second plurality of photovoltaic cells includes a second portion of the first contact layer disposed over the surface of the substrate, a second portion of the absorber layer disposed over the second portion of the first contact layer, and a second portion of the second contact layer disposed over the second portion of the absorber layer. The second portion of the first contact layer is disposed between two second P1 scribe lines. A second P2 scribe line is formed through the second portion of the absorber layer. A second P3 scribe line extends through the second portion of the second contact layer and the second portion of the absorber layer. The two second P1 scribe lines, the second P2 scribe line, and the second P3 scribe line are serially positioned in a second direction that is parallel to the surface of the substrate and that is opposite to the first direction. A first electrode is electrically connected to the first end of the first and second plurality of photovoltaic cells. A second electrode is electrically connected to the second end of the first plurality of photovoltaic cells. A third electrode is electrically connected to the second end of the second plurality of photovoltaic cells.

Embodiments of the disclosure describe a photovoltaic device assembly including an external connection that is configured to be connected to an external connection of an alternate type photovoltaic module. The photovoltaic device assembly includes an anodic electrode coupled to the external connection of the thin-film photovoltaic module and an absorber layer disposed between a first contact layer and a second contact layer. The anodic electrode is configured to be coupled to a cathodic electrode of the alternate type photovoltaic module. A first scribe line of a first type defines a first opening in the first contact layer and is disposed a first distance from the anodic electrode on a first side of the anodic electrode. A second scribe line of the first type defines a second opening in the first contact layer and is disposed the first distance from the anodic electrode on a second side of the anodic electrode. A third scribe line of a second type defines a third opening in the absorber layer and is disposed a second distance from the anodic electrode on the first side of the anodic electrode. A fourth scribe line of the second type defines a fourth opening in the absorber layer and is disposed the second distance from the anodic electrode on the second side of the anodic electrode.

Embodiments of the disclosure describe a photovoltaic device including a first photovoltaic cell assembly, a second photovoltaic cell assembly, and a common electrode. The first photovoltaic cell assembly includes a first group of thin-film photovoltaic cells and a second group of photovoltaic cells. Thin-film photovoltaic cells included in the first group are electrically connected in series and photovoltaic cells included in the second group are electrically connected in series. The second photovoltaic cell assembly includes a third group of thin-film photovoltaic cells and a fourth group of photovoltaic cells. Thin-film photovoltaic cells included in the third group are electrically connected in series and photovoltaic cells included in the fourth group are electrically connected in series. The photovoltaic device includes an electrical connection of the first photovoltaic cell assembly and the second photovoltaic cell assembly. The electrical connection is configured to match a voltage at maximum power (Vmp) generated by the first group and the third group and by the second group and the fourth group. The common electrode is electrically connected to an anode end of the first photovoltaic cell assembly and an anode end of the second photovoltaic cell assembly.

Embodiments of the disclosure describe a photovoltaic device assembly including a first set of cells, a second set of cells, and an anode that is common to the first set of cells and the second set of cells. The first set of cells includes first groups of thin-film photovoltaic cells electrically connected in a first series and second groups of photovoltaic cells electrically connected in a second series. The first series is electrically connected in parallel with the second series in the first set of cells. The second set of cells includes third groups of thin-film photovoltaic cells electrically connected in a third series and fourth groups of photovoltaic cells electrically connected in a fourth series. The third series is electrically connected in parallel with the fourth series in the second set of cells. The anode is disposed between a first cathode and a second cathode. The first cathode and the second cathode include electrical connections that electrically connect the first set of cells in parallel with the second set of cells. The electrical connections are configured to match a voltage at maximum power (Vmp) generated by the first set of cells and the second set of cells.

Embodiments of the disclosure describe a method including connecting a first photovoltaic module and a second photovoltaic module by an electrical connection. The first photovoltaic module includes a first group of thin-film photovoltaic cells and a second group of photovoltaic cells. Thin-film photovoltaic cells included in the first group are electrically connected in series and photovoltaic cells included in the second group are electrically connected in series. The second photovoltaic module includes a third group of thin-film photovoltaic cells and a fourth group of photovoltaic cells. Thin-film photovoltaic cells included in the third group are electrically connected in series and photovoltaic cells included in the fourth group are electrically connected in series. The method further includes disposing a common electrode between the first group and the third group. The common electrode electrically connects the first group and the third group. The electrical connection is configured to match a voltage at maximum power (Vmp) generated by the first group and the third group and by the second group and the fourth group.

Embodiments of the disclosure describe a photovoltaic device assembly that includes first photovoltaic modules and second photovoltaic modules. A first electrical circuited includes a first plurality of the first photovoltaic modules that are connected in series. The first photovoltaic modules include an absorber layer with a first material that has a first optical bandgap. A second electrical circuit includes a second plurality of the second photovoltaic modules that are connected in series. The second photovoltaic modules include an absorber layer with a second material that has a second optical bandgap that is less than the first optical bandgap. During operation, a second photovoltaic module of the second photovoltaic modules is positioned to receive electromagnetic radiation transmitted through a first photovoltaic module of the first photovoltaic modules. The first electrical circuit and the second electrical circuit are connected in parallel. During operation, a first operating voltage generated by the first electrical circuit is different from a second operating voltage generated by the second electrical circuit.

Embodiments of the disclosure describe a photovoltaic device assembly including a first circuit and a second circuit. The first circuit electrically connects a first plurality of thin-film photovoltaic modules between a first positive node and a first negative node. The thin-film photovoltaic modules include a first material with a first optical bandgap. The first plurality of the thin-film photovoltaic modules are connected in parallel strings. The second circuit electrically connects a second plurality of photovoltaic modules between a second positive node and a second negative node. The photovoltaic modules include a second material with a second optical bandgap that is less than the first optical bandgap. The second plurality of the photovoltaic modules are connected in series. A photovoltaic module of the photovoltaic modules is positioned to receive electromagnetic radiation transmitted through a thin-film photovoltaic module of the thin-film photovoltaic modules. An inverter is connected to the first positive node, the first negative node, the second positive node, and the second negative node. The inverter has a voltage rating that is greater than a first operating voltage generated by the first circuit and a second operating voltage generated by the second circuit.

Embodiments of the disclosure describe a method that includes connecting, in a first circuit, thin-film photovoltaic modules in parallel. The thin-film photovoltaic modules have corresponding absorber layers that include a first material with a first optical bandgap. Each of the thin-film photovoltaic modules includes a first number of thin-film photovoltaic cells connected in series. The method further includes connecting, in a second circuit, photovoltaic modules in series. The photovoltaic modules have corresponding absorber layers that include a second material with a second optical bandgap that is less than the first optical bandgap. Each of the photovoltaic modules includes a second number of photovoltaic cells connected in series. The method further includes forming a parallel circuit by connecting the first circuit in parallel with the second circuit. An operating voltage of the parallel circuit is based on a least common multiple (LCM) of the first number and the second number. A photovoltaic module of the photovoltaic modules is positioned to receive electromagnetic radiation transmitted through a thin-film photovoltaic module of the thin-film photovoltaic modules.

Embodiments of the disclosure describe a photovoltaic device assembly including thin-film photovoltaic cells and photovoltaic cells. The thin-film photovoltaic cells have corresponding absorber layers that include a first material. The photovoltaic cells are disposed below the thin-film photovoltaic cells such that a photovoltaic cell of the photovoltaic cells is positioned to receive electromagnetic radiation transmitted through a thin-film photovoltaic cell of the thin-film photovoltaic cells. The photovoltaic cells have corresponding absorber layers that include a second material. An electrical conductor is disposed between the thin-film photovoltaic cells and the photovoltaic cells. The electrical conductor forms a first electrical path between an anode end of the thin-film photovoltaic cells and an anode end of the photovoltaic cells and a second electrical path between a cathode end of the thin-film photovoltaic cells and a cathode end of the photovoltaic cells. The first electrical path and the second electrical path are configured to match a voltage generated at nominal operating cell temperature (NOCT) by the thin-film photovoltaic cells and by the photovoltaic cells.

Embodiments of the disclosure describe a photovoltaic device including sets of series connected first photovoltaic cells having corresponding absorber layers that include a first material. The sets of the series connected first photovoltaic cells are electrically connected in parallel. The photovoltaic device includes series connected second photovoltaic cells disposed below the first photovoltaic cells such that a second photovoltaic cell of the second photovoltaic cells is positioned to receive electromagnetic radiation transmitted through a first photovoltaic cell of the first photovoltaic cells. The second photovoltaic cells having corresponding absorber layers that include a second material. The photovoltaic device further includes an electrical conductor disposed between the first photovoltaic cells and the second photovoltaic cells. The electrical conductor forms a first electrical path between an anode end of the first photovoltaic cells and an anode end of the second photovoltaic cells and a second electrical path between a cathode end of the first photovoltaic cells and a cathode end of the second photovoltaic cells. The first electrical path and the second electrical path are configured to match a voltage generated at nominal operating cell temperature (NOCT) by the first photovoltaic cells and by the second photovoltaic cells.

Embodiments of the disclosure describe a method including disposing photovoltaic cells below thin-film photovoltaic cells such that a photovoltaic cell of the photovoltaic cells is positioned to receive electromagnetic radiation transmitted through a thin-film photovoltaic cell of the thin-film photovoltaic cells. The thin-film photovoltaic cells have corresponding absorber layers that include a first material and the photovoltaic cells have corresponding absorber layers that include a second material. The method further includes connecting the photovoltaic cells and the thin-film photovoltaic cells by an electrical connection configured to match a voltage generated by the photovoltaic cells and the thin-film photovoltaic cells at nominal operating cell temperature (NOCT). The electrical connection includes an anodic electrode and the anodic electrode electrically connects a first group of the thin-film photovoltaic cells having a first cathodic electrode and a second group of the thin-film photovoltaic cells having a second cathodic electrode.

According to an aspect of the present disclosure there is provided a photovoltaic device, comprising:
a first photovoltaic cell assembly including a first group of thin-film photovoltaic cells and a second group of photovoltaic cells, thin-film photovoltaic cells included in the first group are electrically connected in series and photovoltaic cells included in the second group are electrically connected in series;
a second photovoltaic cell assembly including a third group of thin-film photovoltaic cells and a fourth group of photovoltaic cells, thin-film photovoltaic cells included in the third group are electrically connected in series and photovoltaic cells included in the fourth group are electrically connected in series;
a common electrode; and
an electrical connection of the first photovoltaic cell assembly and the second photovoltaic cell assembly, the electrical connection configured to match a voltage at maximum power (Vmp) generated by the first group and the third group and by the second group and the fourth group, wherein the common electrode is electrically connected to:
   an anode end of the first photovoltaic cell assembly; and
   an anode end of the second photovoltaic cell assembly.

The first photovoltaic cell assembly and the second photovoltaic cell assembly may be electrically connected in parallel.

The common electrode may be common to a first electrode that is coupled to a cathode end of the first photovoltaic cell assembly and a second electrode that is coupled to a cathode end of the second photovoltaic cell assembly.

The thin-film photovoltaic cells included in the first group may be positioned between the photovoltaic cells included in the second group and a source of electromagnetic radiation when power is being generated by the photovoltaic device.

The photons received by the photovoltaic cells included in the second group may be transmitted through the thin-film photovoltaic cells included in the first group.

The thin-film photovoltaic cells included in the first group may include a first material having a first optical bandgap and the photovoltaic cells included in the second group may include a second material having a second optical bandgap that is less than the first optical bandgap.

The first material may include a perovskite.

The Vmp may be less than 100 volts at nominal operating cell temperature (NOCT).

According to another aspect of the present disclosure there is provided a photovoltaic device assembly, comprising:
a first set of cells including first groups of thin-film photovoltaic cells electrically connected in a first series and second groups of photovoltaic cells electrically connected in a second series, the first series is electrically connected in parallel with the second series in the first set of cells;
a second set of cells including third groups of thin-film photovoltaic cells electrically connected in a third series and fourth groups of photovoltaic cells electrically connected in a fourth series, the third series is electrically connected in parallel with the fourth series in the second set of cells; and
an anode that is common to the first set of cells and the second set of cells, the anode disposed between a first cathode and a second cathode, wherein the anode, the first cathode, and the second cathode include electrical connections that electrically connect the first set of cells in parallel with the second set of cells, and wherein the electrical connections are configured to match a voltage at maximum power (Vmp) generated by the first set of cells and the second set of cells.

The photovoltaic device assembly may further comprise: a third set of cells including fifth groups of thin-film photovoltaic cells electrically connected in a fifth series and sixth groups of thin-film photovoltaic cells electrically connected in a sixth series, the fifth series is electrically connected in parallel with the sixth series in the third set of cells.

The electrical connections may electrically connect the third set of cells in parallel with the first set of cells and in parallel with the second set of cells, and wherein the electrical connections may be configured to match the Vmp generated by the first set of cells, the second set of cells, and the third set of cells.

The third set of cells may include a seventh group of thin-film photovoltaic cells electrically connected in a seventh series, and wherein the seventh series is electrically connected in parallel with the fifth series and in parallel with the sixth series.

The Vmp may be than 100 volts at nominal operating cell temperature (NOCT).

The first groups of thin-film photovoltaic cells electrically connected in the first series may include a first material having a first optical bandgap and the second groups of photovoltaic cells electrically connected in the second series may include a second material having a second optical bandgap that is less than the first optical bandgap.

The first material may include a perovskite.

According to another aspect of the present disclosure there is provided a photovoltaic device assembly, comprising:
thin-film photovoltaic cells having corresponding absorber layers that include a first material;
photovoltaic cells disposed below the thin-film photovoltaic cells wherein a photovoltaic cell of the photovoltaic cells is positioned to receive electromagnetic radiation transmitted through a thin-film photovoltaic cell of the thin-film photovoltaic cells, the photovoltaic cells having corresponding absorber layers that include a second material; and
an electrical conductor disposed between the thin-film photovoltaic cells and the photovoltaic cells, the electrical conductor forming a first electrical path between an anode end of the thin-film photovoltaic cells and an anode end of the photovoltaic cells and a second electrical path between a cathode end of the thin-film photovoltaic cells and a cathode end of the photovoltaic cells, the first electrical path and the second electrical path are configured to match a voltage generated at nominal operating cell temperature (NOCT) by the thin-film photovoltaic cells and by the photovoltaic cells.

The voltage generated at NOCT may be less than 100 volts.

The first material may have a first optical bandgap in a range of 1.4 to 1.8 eV and the second material may have a second optical bandgap that is less than the first optical bandgap.

The first material may include a perovskite and the second material may include silicon.

The electrical conductor may include an anodic electrode between a first cathodic electrode of a first set of the thin-film photovoltaic cells and a second cathodic electrode of a second set of the thin-film photovoltaic cells.

The anodic electrode may include a flat ribbon that is disposed on a first contact layer and between the absorber layers that include the first material and a second contact layer.

The anodic electrode may include a wire having a first cross-sectional shape that is at least one of circular, triangular, or hemispherical and the first cathodic electrode may include a wire having a second cross-sectional shape that is different from the first cross-sectional shape.

The first set of the thin-film photovoltaic cells may be electrically connected in parallel with the second set of the thin-film photovoltaic cells.

The photovoltaic cells may be electrically connected in series.

According to another aspect of the present disclosure there is provided a photovoltaic device, comprising:
sets of series connected first photovoltaic cells having corresponding absorber layers that include a first material, the sets of the series connected first photovoltaic cells are electrically connected in parallel;
series connected second photovoltaic cells disposed below the first photovoltaic cells wherein a second photovoltaic cell of the second photovoltaic cells is positioned to receive electromagnetic radiation transmitted through a first photovoltaic cell of the first photovoltaic cells, the second photovoltaic cells having corresponding absorber layers that include a second material; and
an electrical conductor disposed between the first photovoltaic cells and the second photovoltaic cells, the electrical conductor forming a first electrical path between an anode end of the first photovoltaic cells and an anode end of the second photovoltaic cells and a second electrical path between a cathode end of the first photovoltaic cells and a cathode end of the second photovoltaic cells, the first electrical path and the second electrical path are configured to match a voltage generated at nominal operating cell temperature (NOCT) by the first photovoltaic cells and by the second photovoltaic cells.

The electrical conductor may include an anodic electrode between a first cathodic electrode of a first set of the first photovoltaic cells and a second cathodic electrode of a second set of the first photovoltaic cells.

The anodic electrode may include a wire having a first cross-sectional shape that is at least one of circular, triangular, or hemispherical and the first cathodic electrode may include a wire having a second cross-sectional shape that is different from the first cross-sectional shape.

The voltage generated at NOCT may be less than 100 volts.

The first material may have a first optical bandgap in a range of 1.4 to 1.8 eV and the second material may have a second optical bandgap that is less than the first optical bandgap.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, may admit to other equally effective embodiments.
Figure 1A schematically illustrates groups of thin-film photovoltaic cells and groups of photovoltaic cells connected in series.
Figure 1B schematically illustrates groups of thin-film photovoltaic cells and groups of photovoltaic cells connected in parallel.
Figure 2A illustrates a schematic representation of groups of series connected photovoltaic cells connected in series of a first module with a group of series connected thin-film photovoltaic cells of a second module, according to one or more embodiments of the disclosure.
Figure 2B illustrates a first stacked module assembly schematic, according to one or more embodiments of the disclosure.
Figure 2C illustrates a generalized first stacked module assembly schematic, according to one or more embodiments of the disclosure.
Figure 3A illustrates a schematic representation of parallel sets of series connected groups of photovoltaic cells of a first module connected in series with a group of series connected thin-film photovoltaic cells of a second module, according to one or more embodiments of the disclosure.
Figure 3B illustrates a second stacked module assembly schematic, according to one or more embodiments of the disclosure.
Figure 3C illustrates a generalized second stacked module assembly schematic, according to one or more embodiments of the disclosure.
Figure 4A illustrates a schematic representation of parallel sets of series connected groups of photovoltaic cells of a first module connected in parallel with parallel sets of series connected groups of thin-film photovoltaic cells of a second module, according to one or more embodiments of the disclosure.
Figure 4B illustrates a third stacked module assembly schematic, according to one or more embodiments of the disclosure.
Figure 4C illustrates a generalized third stacked module assembly schematic, according to one or more embodiments of the disclosure.
Figure 5A illustrates a schematic representation of parallel sets of series connected groups of photovoltaic cells of a first module connected in parallel with parallel sets of series connected groups of thin-film photovoltaic cells of a second module, according to one or more embodiments of the disclosure.
Figure 5B illustrates a representation of a thin-film photovoltaic cell width, according to one or more embodiments of the disclosure.
Figure 5C illustrates a fourth stacked module assembly schematic, according to one or more embodiments of the disclosure.
Figure 6A illustrates a schematic representation of groups of series connected photovoltaic cells of a first module connected in parallel with parallel sets of groups of series connected thin-film photovoltaic cells of a second module, according to one or more embodiments of the disclosure.
Figure 6B illustrates a fifth stacked module assembly schematic, according to one or more embodiments of the disclosure.
Figure 7A illustrates a schematic side view of a first thin-film photovoltaic module, according to one or more embodiments of the disclosure
Figure 7B illustrates a plan view of the first thin-film photovoltaic module illustrated in Figure 7A, according to one or more embodiments of the disclosure.
Figure 8A illustrates a schematic side view of a second thin-film photovoltaic module, according to one or more embodiments of the disclosure
Figure 8B illustrates a plan view of the second thin-film photovoltaic module illustrated in Figure 8A, according to one or more embodiments of the disclosure.
Figure 9A illustrates a schematic side view of a third thin-film photovoltaic module, according to one or more embodiments of the disclosure
Figure 9B illustrates a plan view of the third thin-film photovoltaic module illustrated in Figure 9A, according to one or more embodiments of the disclosure.
Figure 10 illustrates an example combination of photovoltaic modules connected in series and thin-film photovoltaic modules separately connected in parallel at a string level, according to one or more embodiments of the disclosure.
Figure 11 is a flow diagram illustrating a method for matching a voltage at maximum power (Vmp), according to one or more embodiments of the disclosure.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the disclosure generally relate to photovoltaic modules and methods for power generation parameter matching when exposed to electromagnetic radiation. In some embodiments, a photovoltaic device includes a first photovoltaic module and a second photovoltaic module. In some embodiments, the first photovoltaic module includes a first group of thin-film photovoltaic cells and a second group of photovoltaic cells. In one or more embodiments, the first group of thin-film photovoltaic cells includes amorphous silicon (a-Si) photovoltaic cells, cadmium telluride (CdTe) photovoltaic cells, copper indium gallium selenide (CIGS) photovoltaic cells, organic photovoltaic cells (OPV), perovskite photovoltaic cells, Kesterite (CZTS) solar cells, dye-sensitized solar cells (DSSCs), quantum dot solar cells, or other types of solar cells. In various embodiments, the second group of photovoltaic cells includes monocrystalline silicon photovoltaic cells, polycrystalline silicon photovoltaic cells, thin-film silicon photovoltaic cells, CIGS containing solar cells, CdTe containing solar cells, or other types of solar cells. In certain embodiments, the second group includes half-cut silicon M10 cells. In some embodiments, photovoltaic cells included in the second group may be electrically connected in series, in parallel, or as a first series connected in parallel with a second series.

In some embodiments, thin-film photovoltaic cells (e.g., perovskite photovoltaic cells) included in the first group of photovoltaic cells may be arranged in a stacked configuration with photovoltaic cells (e.g., silicon containing solar cells) included in the second group of photovoltaic cells disposed below the thin-film photovoltaic cells such that electromagnetic radiation, or often referred to herein as "light", transmitted through the thin-film photovoltaic cells can be received by the second group of photovoltaic cells. Thin-film photovoltaic cells included in the first group may be electrically connected in series, in parallel, or as a series connected array of thin-film photovoltaic cells that are connected in parallel with another series connected array of thin-film photovoltaic cells. In various embodiments, a number of thin-film photovoltaic cells included in the first group of photovoltaic cells is greater than, equal to, or less than a number of photovoltaic cells (e.g., silicon containing solar cells) included in the second group of photovoltaic cells.

In one or more embodiments, the first photovoltaic module, which is coupled to the second photovoltaic module, includes a third group of thin-film photovoltaic cells and a fourth group of photovoltaic cells. In certain embodiments, a photovoltaic device, which includes the first and second photovoltaic modules, includes a common electrode of the first group and the third group. In some embodiments, an electrical connection of the first photovoltaic module and the second photovoltaic module is configured to match a voltage at maximum power (Vmp) generated by the first group and the third group and by the second group and the fourth group. By matching the Vmp, the photovoltaic device is capable of generating electric power at an electrical utility (i.e., electric load-serving entities (LSEs)) power generation scale. In some embodiments, a substantial number of the photovoltaic devices can be connected in series for AC power generation even when inverter system-level voltages are limited to around, for example, 1,500 V.

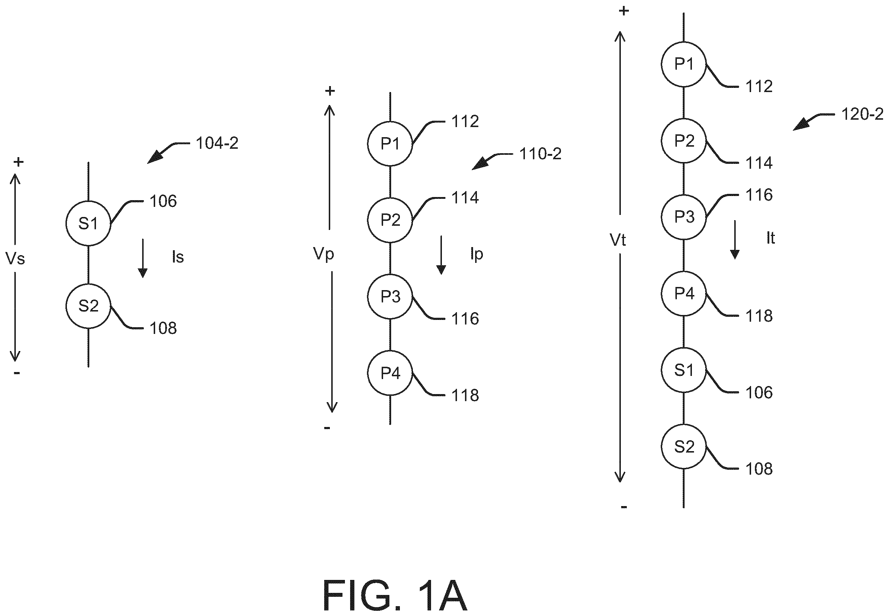

Figure 1A schematically illustrates groups of thin-film photovoltaic cells and groups of photovoltaic cells connected in series. As shown, Figure 1A includes an equivalent circuit 104-2 that includes a first group of photovoltaic cells, wherein the first group includes a first photovoltaic cell 106 and a second photovoltaic cell 108. The equivalent circuit 104-2 includes a current Iₛ that flows through both the first photovoltaic cell 106 and the second photovoltaic cell 108. There is also a voltage Vₛ formed across the series connected first and second photovoltaic cells 106, 108, collectively. In some embodiments, the first and second photovoltaic cells 106, 108 may be silicon photovoltaic cells, such as monocrystalline silicon photovoltaic cells or polycrystalline silicon photovoltaic cells, or CIGS containing solar cells, or other types of solar cells. In other embodiments, the first and second photovoltaic cells 106, 108 can be thin-film silicon photovoltaic cells or other types of solar cells. In general, the first and second photovoltaic cells 106, 108 are configured to generate electrical current/voltage from the exposure to photons via the photovoltaic effect. The first and second photovoltaic cells 106, 108 have absorber layers (not shown) including a first material (e.g., silicon layers) having a first density and a first optical bandgap (e.g., about 1.15 eV). In various examples, the first density can be based on mass or volume.

Figure 1A includes an equivalent circuit 110-2 that includes a first group of thin-film photovoltaic cells, wherein the first group includes a first thin-film photovoltaic cell 112, a second thin-film photovoltaic cell 114, a third thin-film photovoltaic cell 116, and a fourth thin-film photovoltaic cell 118. In the equivalent circuit 110-2, there is a voltage Vₚ across the first, second, third, and fourth thin-film photovoltaic cells 112, 114, 116, 118, collectively. The first, second, third, and fourth thin-film photovoltaic cells 112, 114, 116, 118 have absorber layers (not shown) including a second material (e.g., perovskite layers) having a second density and a second optical bandgap (e.g., about 1.4 to 1.8 eV such as 1.6 eV). In one or more examples, the second density may be based on mass or volume. In some embodiments, the second density is greater than the first density and the second optical bandgap is greater than the first optical bandgap. A current Iₚ flows through the first thin-film photovoltaic cell 112, the second thin-film photovoltaic cell 114, the third thin-film photovoltaic cell 116, and the fourth thin-film photovoltaic cell 118.

Figure 1A also includes an equivalent circuit 120-2 that includes the first group of photovoltaic cells, which include the first photovoltaic cell 106 and the second photovoltaic cell 108, connected in series with the first group of thin-film photovoltaic cells, which include the first thin-film photovoltaic cell 112, the second thin-film photovoltaic cell 114, the third thin-film photovoltaic cell 116, and the fourth thin-film photovoltaic cell 118. In some embodiments, the first, second, third, and fourth thin-film photovoltaic cells 112, 114, 116, 118 are positioned over the first and second photovoltaic cells 106, 108 in a stacked configuration such that light can pass through the first, second, third, and fourth thin-film photovoltaic cells 112, 114, 116, 118 and then the light can be received by the first and second photovoltaic cells 106, 108. In the equivalent circuit 120-2, a voltage Vt is across the first thin-film photovoltaic cell 112, the second thin-film photovoltaic cell 114, the third thin-film photovoltaic cell 116, the fourth thin-film photovoltaic cell 118, the first photovoltaic module 106, and the second photovoltaic cell 108 collectively. A current It flows through each of the first, second, third, and fourth thin-film photovoltaic cell 112, 114, 116, 118 and the first and second photovoltaic cell 106, 108.

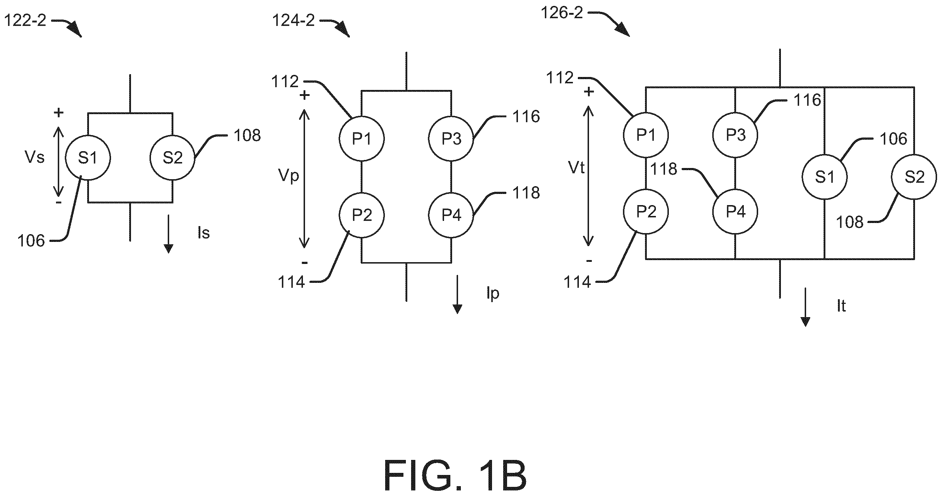

Figure 1B schematically illustrates groups of thin-film photovoltaic cells and groups of photovoltaic cells connected in parallel. As shown, an equivalent circuit 122-2 includes a set of two groups of photovoltaic cells, where a first group of the photovoltaic cells includes the first photovoltaic cell 106 and a second group of the photovoltaic cells includes the second photovoltaic cell 108. In the equivalent circuit 122-2, the current Iₛ is equal to the sum of a current flowing through the first photovoltaic cell 106 and a current flowing through the second photovoltaic cell 108. Accordingly, unlike in the equivalent circuit 104-2 in which the same current Iₛ flows through both the first and second photovoltaic cells 106, 108, in the equivalent circuit 122-2, a first portion of the current Iₛ flows through the first photovoltaic cell 106 and a second portion of the current Iₛ flows through the second photovoltaic cell 108. In the equivalent circuit 122-2, the voltage Vₛ is across each of the first and second photovoltaic cells 106, 108 whereas the voltage Vₛ is across the first and second photovoltaic cells 106, 108 collectively in the equivalent circuit 104-2.

Figure 1B includes an equivalent circuit 124-2 includes a set of two groups of thin-film photovoltaic cells, where the first group of thin-film photovoltaic cells includes the first thin-film photovoltaic cell 112 and the second thin-film photovoltaic cell 114, and the second group of thin-film photovoltaic cells includes the third thin-film photovoltaic cell 116 and the fourth thin-film photovoltaic cell 118. As shown in the equivalent circuit 124-2, the first thin-film photovoltaic cell 112 and the second thin-film photovoltaic cell 114 are connected in a first series, and the third thin-film photovoltaic cell 116 and the fourth thin-film photovoltaic cell 118 are connected in a second series. The first group and the second group of thin-film photovoltaic cells are connected in parallel. The voltage Vₚ is across the first thin-film photovoltaic cell 112 and the second thin-film photovoltaic cell 114 collectively. The voltage Vₚ is also across the third thin-film photovoltaic cell 116 and the fourth thin-film photovoltaic cell 118 collectively. The current Iₚ is equal to a sum of a first current flowing through the first thin-film photovoltaic cell 112 and the second thin-film photovoltaic cell 114 and a second current flowing through the third thin-film photovoltaic cell 116 and the fourth thin-film photovoltaic cell 118.

Figure 1B also includes an equivalent circuit 126-2 that includes two groups of thin-film photovoltaic cells and two groups of photovoltaic cells. The two groups of thin-film photovoltaic cells include a first group of thin-film photovoltaic cells that include the first and second photovoltaic cells 112, 114, and the second group of thin-film photovoltaic cells that include the third and fourth thin-film photovoltaic cells 116, 118. The two groups of photovoltaic cells include a first group of photovoltaic cells that include the first photovoltaic cell 106, and the second group of photovoltaic cells that include the second photovoltaic cell 108. In this example, a first module that includes the two groups of thin-film photovoltaic cells, which includes the first, second, third, and fourth thin-film photovoltaic cells 112, 114, 116, 118, is positioned over a second module that includes the first and second photovoltaic cells 106, 108 in a stacked configuration such that light can pass through the first module and then the light can be received by the first and second photovoltaic cells 106, 108 disposed in the second module. In the equivalent circuit 126-2, the voltage Vt is across the first thin-film photovoltaic cell 112 and the second thin-film photovoltaic cell 114, and also across the third thin-film photovoltaic cell 116 and the fourth thin-film photovoltaic cell 118. Additionally, the voltage Vt is across the first photovoltaic cell 106 and also across the second photovoltaic cell 108. The current It is equal to a sum of a first current flowing through the first thin-film photovoltaic cell 112 and the second thin-film photovoltaic cell 114, a second current flowing through the third thin-film photovoltaic cell 116 and the fourth thin-film photovoltaic cell 118, a third current flowing through the first photovoltaic cell 106, and a fourth current flowing through the second photovoltaic cell 108.

There are several challenges to using the first and second photovoltaic cells 106, 108 and the first, second, third, and fourth thin-film photovoltaic cells 112, 114, 116, 118 in the stacked configuration for electric power generation applications. These challenges include form factor mismatches between photovoltaic cells and thin-film photovoltaic cells. One example form factor for the photovoltaic cells is an 1134 millimeter by 2382 millimeter panel (module) using M10 wafers. The 1134 millimeter by 2382 millimeter panel typically includes one string of 72 cells in series and generates about 50 V at open circuit (Voc) and a moderately lower operating voltage. A variation on this example includes half-cut cells resulting in two parallel strings of 72 half-cut cells which also generates about 50 V at Voc. Another example form factor includes shingled cells, which often result in five or six strings of 72 shingled cells. As wafer size increases to M12, panel (module) dimensions increase to 1303 millimeters by 2384 millimeters, commonly with 132 half-cut cells and resulting in two parallel strings of 66 cells. The two parallel strings of 66 cells generate about 45 V at Voc and have a correspondingly lower operating voltage. However, in one thin-film photovoltaic cell example, a form factor for perovskite photovoltaic cells is a 1216 millimeters by 2300 millimeters panel (module) with 268 cells in series and generates about 225 V at Voc. Accordingly, the form factors and the generated voltage magnitudes at Voc for the photovoltaic cells and the perovskite photovoltaic cells are significantly different.

The challenges to using the photovoltaic cells and thin-film photovoltaic cells such as the perovskite photovoltaic cells for electric power generation applications include inverter system-level voltage limitations. Typically, inverter system-level voltages are limited to around 1500 V. Because of this limitation, at Voc, a number of the 1216 millimeters by 2300 millimeters panels (modules) of the perovskite photovoltaic cells connectable in series without exceeding around 1500 V is less than seven which, while common in CdTe applications, is a far smaller number than for silicon solar panels (modules) connectable in series without exceeding around 1500 V, and so might require non-standard designs and installation practices. For example, utility-scale modules typically include strings of photovoltaic modules with the strings each having 25 or more photovoltaic modules due to the installation and maintenance costs associated with each module. In general, a number of modules included in a string scales up with higher inverter system-level voltage limits and scales down with lower inverter system-level voltage limits.

The challenges to using the photovoltaic cells and thin-film photovoltaic cells such as the perovskite photovoltaic cells for electric power generation applications also include differences in behaviors of the photovoltaic cells and the perovskite photovoltaic cells in the stacked configuration. In one photovoltaic cell example, silicon photovoltaic cells are shaded in the stacked configuration to about 33-50 percent of the full-sun intensity which changes the expected behavior of the underlying photovoltaic cells. The silicon photovoltaic cells and the perovskite photovoltaic cells also behave electrically differently with respect to light intensity. For instance, the perovskite photovoltaic cells reach peak efficiency at light intensities less than one sun, typically between 0.2 and 0.8 sun. However, the silicon photovoltaic cells reach peak efficiency at full sun intensity and lose Voc and voltage at maximum power (Vmp) for light intensities less than one sun which fall more quickly in particular at light intensities less than 0.25 sun. Additionally, the silicon photovoltaic cells and the perovskite photovoltaic cells behave differently with respect to changes in temperature. The voltage generated by the perovskite photovoltaic cells changes relatively slowly with temperature, in some instances around -0.13 percent (%) relative to ideal per degree Celsius. However, the voltage generated by the silicon photovoltaic cells changes relatively quickly, e.g., around -0.26 percent (%) relative to ideal per degree Celsius.

Differences in rates of degradation represent another challenge to using the silicon photovoltaic cells and the perovskite photovoltaic cells for electric power generation applications. The silicon photovoltaic cells are likely to degrade at a slower rate than the perovskite photovoltaic cells, especially in the stacked configuration in which the perovskite photovoltaic cells protect the silicon photovoltaic cells from some degradation catalysts (e.g., ultraviolent light). In the context of generation parameter matching for electric power generation applications, a current at short circuit (Isc) may become mismatched faster than Voc due to degradation of the perovskite photovoltaic cells.

### Power Generation Parameter Matching Examples

### A. Current Matching Examples

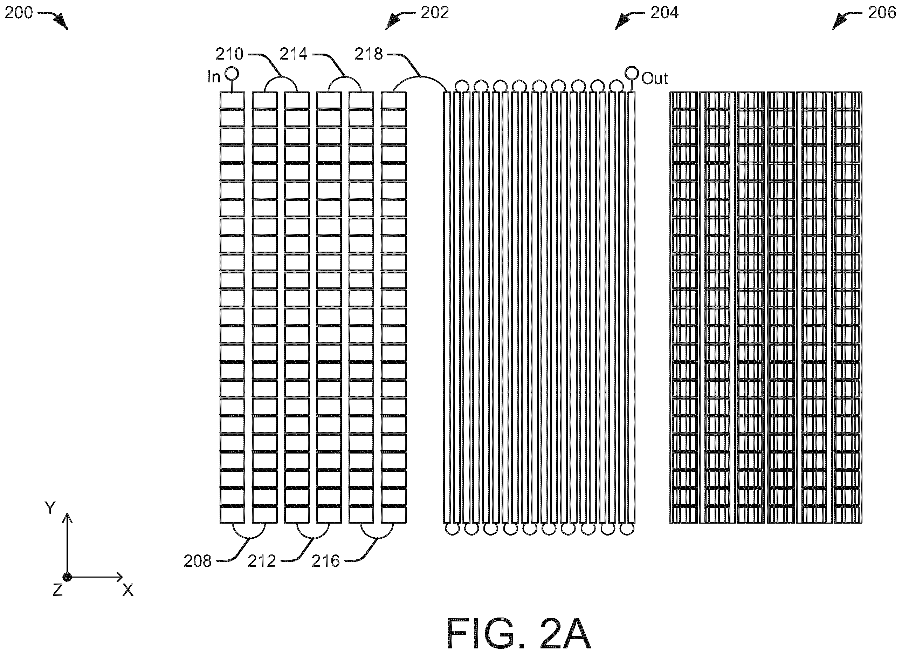

Figure 2A illustrates a schematic representation 200 of groups of series connected photovoltaic cells of a first module connected in series with a group of series connected thin-film photovoltaic cells of a second module. Particular thin-film photovoltaic cell examples are described with respect to perovskite photovoltaic cells; however, it is to be appreciated that the particular examples apply to other thin-film photovoltaic cells as well. As shown, the schematic representation 200 includes six groups of series connected photovoltaic cells 202 of the first module, a group of series connected perovskite photovoltaic cells 204 of the second module, and a stacked module assembly 206 that includes the first module and the second module. In the stacked module assembly 206, the first module may be disposed below the second module such that photons which pass through the group of perovskite photovoltaic cells 204 can be received by the groups of photovoltaic cells 202. In some embodiments, the groups of photovoltaic cells 202 of the first module include 144 half-cut M10 cells having a surface area of about 165.3 square centimeters. In one or more examples, if the groups of photovoltaic cells 202 are shaded by the group of perovskite photovoltaic cells 204 of the second module, then the groups of photovoltaic cells 202 generate about 2.23 Amps (A) at short circuit (Isc) and about 2.14 A at maximum power (Imp).

In various embodiments, the group of perovskite photovoltaic cells 204 includes a glass layer with dimensions of about 1134 millimeters (mm) by 2382 mm. In some embodiments, the glass layer is common to the half-cut M10 cells included in the groups of photovoltaic cells 202. In certain embodiments, the stacked module assembly 206 includes a 15 millimeter border without perovskite photovoltaic cells which is reserved for edge seal. In these embodiments, the resulting perovskite region has dimensions of about 1104 millimeters by 2352 millimeters.

In some embodiments, the group of perovskite photovoltaic cells 204 has a current density at short circuit (Jsc) of about 21.83 mA/cm². In these embodiments, for example, current-matching the groups of photovoltaic cells 202 can be achieved using a perovskite photovoltaic cell width of about 4.45 millimeters which generates about 2.14 A at Imp. This current-matching results in 248 perovskite photovoltaic cells in the group of perovskite photovoltaic cells 204 in some examples.

In various embodiments, by current-matching the groups of photovoltaic cells 202 and the group of perovskite photovoltaic cells 204, a series electrical connection is implementable in the stacked module assembly 206. In one example, in the first module, the series electrical connection includes a first series connection 208 between a first group of 24 series connected photovoltaic cells (e.g., series connected in the -Y-direction) and a second group of 24 series connected photovoltaic cells (e.g., series connected in the +Y-direction); a second series connection 210 between the second group of 24 series connected photovoltaic cells and a third group of 24 series connected photovoltaic cells (e.g., series connected in the -Y-direction); a third series connection 212 between the third group of 24 series connected photovoltaic cells and a fourth group of 24 series connected photovoltaic cells (e.g., series connected in the +Y-direction); a fourth series connection 214 between the fourth group of 24 series connected photovoltaic cells and a fifth group of 24 series connected photovoltaic cells (e.g., series connected in the -Y-direction); a fifth series connection 216 between the fifth group of 24 photovoltaic cells and a sixth group of 24 series connected photovoltaic cells (e.g., series connected in the +Y-direction); and a sixth series connection 218 between the sixth group of 24 series connected photovoltaic cells and the group of series connected perovskite photovoltaic cells 204 (e.g., series connected in the +X-direction). The sixth series connection 218 is configured to electrically connect the groups of photovoltaic cells 202 of the first module in series with the group of perovskite photovoltaic cells 204 of the second module. In one example, the groups of photovoltaic cells 202 may generate about 100.8 V at open circuit (Voc) and the group of perovskite photovoltaic cells 204 can generate about 272.8 V at Voc which corresponds to the stacked module assembly 206 generating about 373.6 V at Voc and about 2.14 A at Imp.

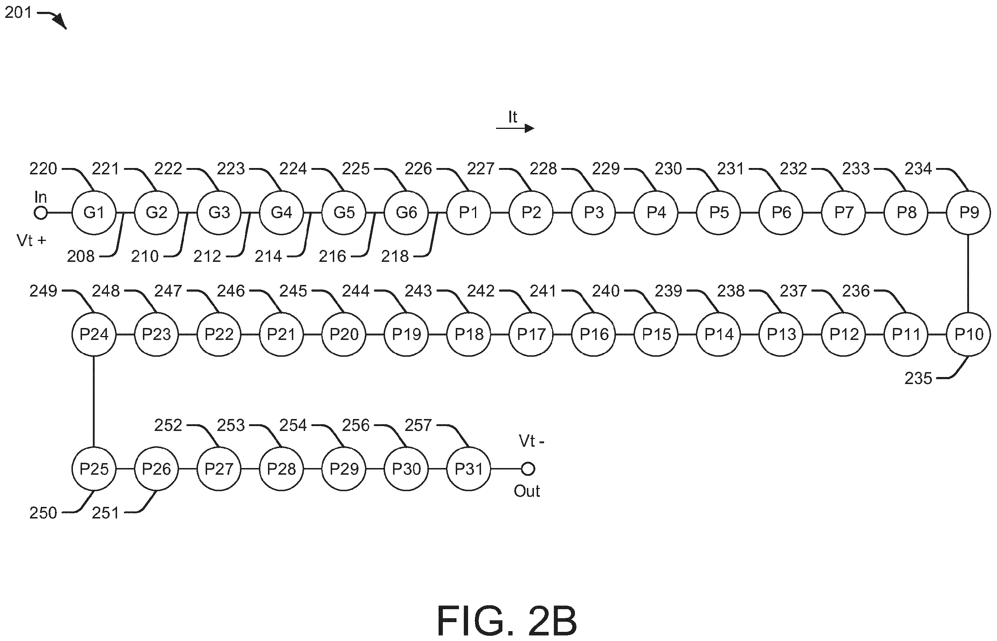

Figure 2B illustrates a first stacked module assembly schematic 201. The schematic 201 represents an equivalent circuit for the stacked module assembly 206. As shown, six groups 220-225 having 24 series connected photovoltaic cells (e.g., S1-S24) each of the first module are connected in series with 31 series connected perovskite photovoltaic cells 226-257 each of the second module.

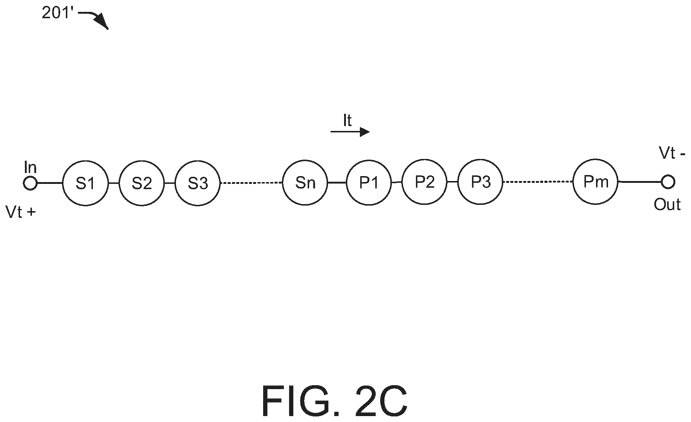

Figure 2C illustrates a generalized first stacked module assembly schematic 201'. The first module includes "n" series connected cells, where the number of series connected cells can vary from one to "n" and "n" is a first integer corresponding to a first number of series connected S cells included in the first module. The second module includes "m" series connected cells, where the number of series connected cells can vary from one to "m" and "m" is a second integer corresponding to a second number of series connected P cells included in the second module. In one or more examples, n may be may be 1, 2, 3, 4, 5, or an integer greater than 5, or an integer greater than 10 or an integer greater than 25, an integer greater than 40, an integer greater than 50, or an integer greater than 100. In various examples, m may be 1, 2, 3, 4, 5, or an integer greater than 5, or an integer greater than 10 or an integer greater than 25, an integer greater than 40, an integer greater than 50, or an integer greater than 100.

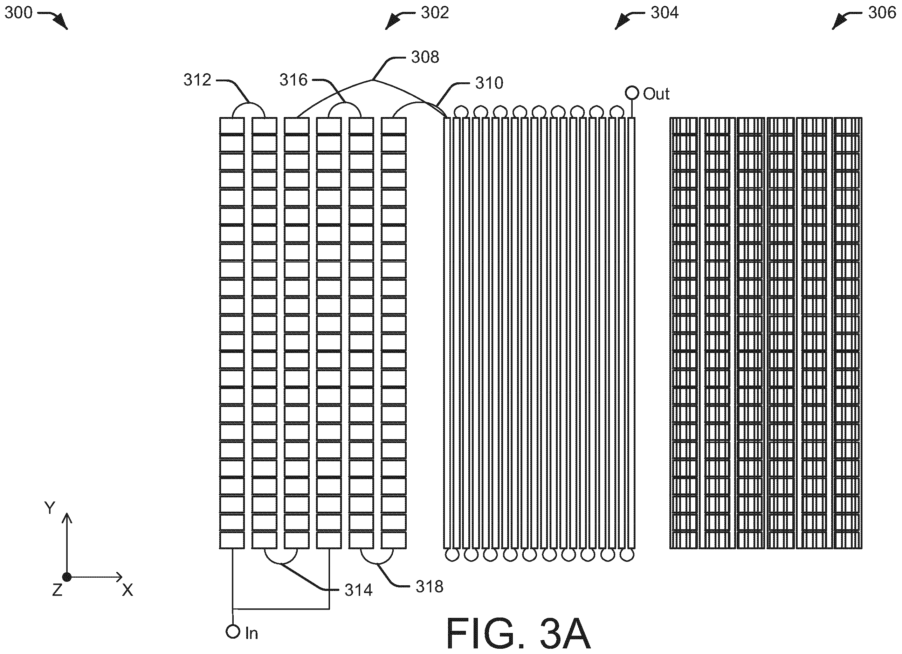

Figure 3A illustrates a schematic representation 300 of parallel sets of series connected groups of photovoltaic cells connected of a first module in series with a group of series connected thin-film photovoltaic cells of a second module. Particular thin-film photovoltaic cell examples are described with respect to perovskite photovoltaic cells; however, it is to be appreciated that the particular examples apply to other thin-film photovoltaic cells as well. The schematic representation 300 is illustrated to include parallel sets of groups of series connected photovoltaic cells 302 of the first module, a group of series connected perovskite photovoltaic cells 304 of the second module, and a stacked module assembly 306 that includes the first module and the second module. In the stacked module assembly 306, the first module may be positioned below the second module such that photons passing through the group of perovskite photovoltaic cells 304 can be received by the groups of photovoltaic cells 302. In some embodiments, the groups of photovoltaic cells 302 of the first module may include the 144 half-cut M10 cells at about 165.3 square centimeters which are included in the groups of photovoltaic cells 202. In one or more embodiments, the groups of photovoltaic cells 302 of the first module may include the 144 half-cut M10 cells in two parallel sets of groups of 72 half-cut M10 cells connected in series. In certain embodiments, the first set including first groups of the 72 half-cut M10 cells is electrically connected in series with the group of perovskite photovoltaic cells 304 of the second module by a first series connection 308 and the second set including second groups of the 72 half-cut M10 cells is electrically connected in series with the group of perovskite photovoltaic cells 304 of the second module by a second series connection 310.

In one example, a first set of 72 half-cut M10 cells include the first group (G1) of 24 series connected photovoltaic cells, the second group (G2) of 24 series connected photovoltaic cells, and the third group (G3) of 24 series connected photovoltaic cells which are interconnected by the series connections 316, 318. A second set of 72 half-cut M10 cells includes a fourth group (G4) of 24 series connected photovoltaic cells, a fifth group (G5) of 24 series connected photovoltaic cells, and a sixth group (G6) of 24 series connected photovoltaic cells which are interconnected by the series connections 312, 314. In the illustrated example, the first set of grouped series connected photovoltaic cells G1, G2, G3 is electrically connected in parallel with the second set of grouped series connected photovoltaic cells G4, G5, G6.

In one example, the parallel sets of the groups of series connected photovoltaic cells 302 generate about 4.46 A at Isc and about 4.28 A at Imp. In some embodiments, in order to match the current of the parallel sets of the groups of series connected photovoltaic cells 302 of the first module, perovskite cells included in the group of series connected perovskite photovoltaic cells 304 of the second module would have a width of about 8.7 millimeters to match at Isc (e.g., 127 perovskite cells) or a width of about 8.9 millimeters to match at Imp (e.g., 124 perovskite cells). In one example, the parallel sets of the groups of series connected photovoltaic cells 302 generate about 50.4 V at Voc and the group of series connected perovskite photovoltaic cells 304 generates about 136.4 V at Voc. In one example, the stacked module assembly 306 generates about 186.8 V at Voc and about 4.28 A at Imp. Compared to the stacked module assembly 206 generating about 373.6 V at Voc and about 2.14 A at Imp, the stacked module assembly 306 generates 50 percent less voltage at Voc. Thus, about twice as many implementations of the stacked module assembly 306 can be installed as a number of the implementations of the stacked module assembly 206 for a particular inverter voltage limit.

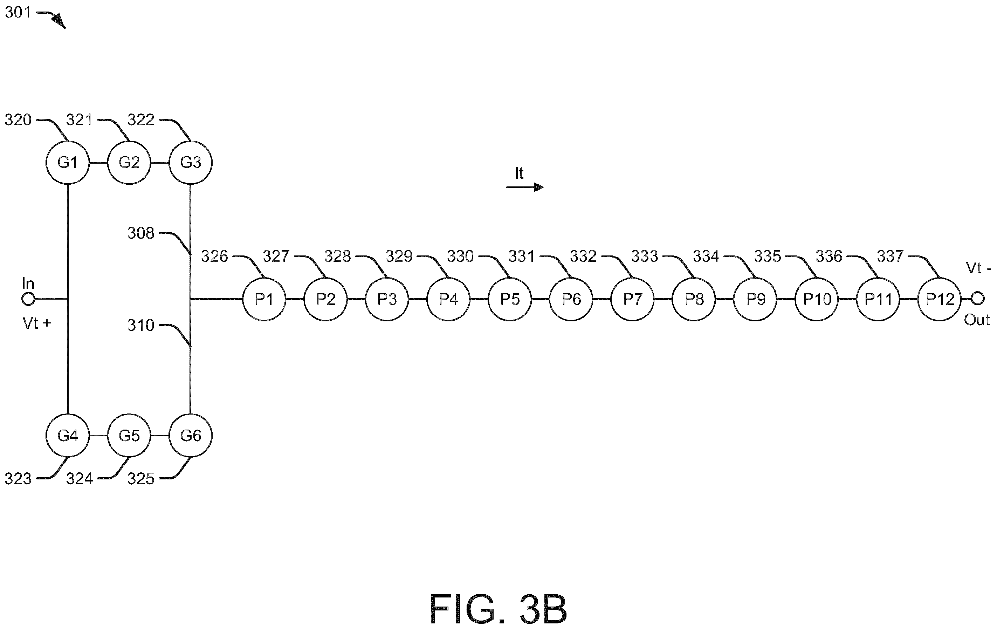

Figure 3B illustrates a second stacked module assembly schematic 301. The schematic 301 represents an equivalent circuit for the stacked module assembly 306. As shown, the first set of three groups 320-322 having 24 series connected photovoltaic cells each is connected in parallel with the second set of three groups 323-325 having 24 series connected photovoltaic cells each. The first set of the three groups 320-322 and the second set of the three groups 323-325 of the first module are connected in series with 12 series connected perovskite photovoltaic cells 326-337 of the second module.

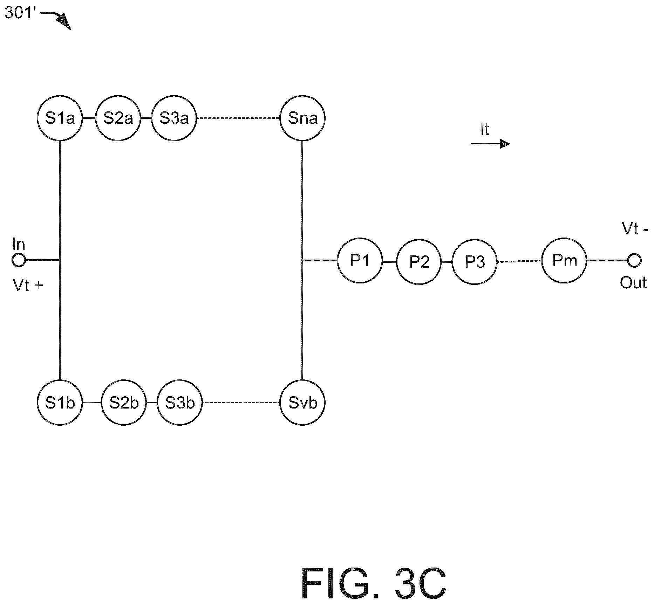

Figure 3C illustrates a generalized second stacked module assembly schematic 301'. The first module includes a group of cells "Sxa" connected in series, where "x" is a first integer corresponding to a first number of series connected S cells included in a first parallel group included the first module, where x varies from 1 to n. The first module also includes a second group of cells "Syb" that are connected in series, where "y" is a second integer generally corresponding to a second number of series connected S cells included in the first module, where y varies from 1 to v. The second module includes cells connected in series with cell "Pz" where "z" is a third integer corresponding to a third number of series connected P cells included in the second module, where z varies from 1 to m. In one or more examples, n and v may be 1, 2, 3, 4, 5, or an integer greater than 5, or an integer greater than 10 or an integer greater than 25, an integer greater than 40, an integer greater than 50, or an integer greater than 100. In various examples, m may be 1, 2, 3, 4, 5, or an integer greater than 5, greater than 25, greater than 40, greater than 50, or greater than 100.

### B. Voltage Matching Examples

As described above, current matching is a technique for power generation optimization which involves ensuring that currents generated by different components (e.g., solar cells) of a power generating circuit are approximately the same. Voltage matching is another technique for power generation optimization that involves ensuring that voltages generated by the different components (e.g., the solar cells) of the power generating circuit are approximately the same. Ideally, both current matching and voltage matching are performed to optimize power generation efficiency; however, for power generation using tandem modules that include thin-film photovoltaic cells stacked with other types of photovoltaic cells formed from a different material, matching both current and voltage may not be practical due to the different electrical properties of the different materials.

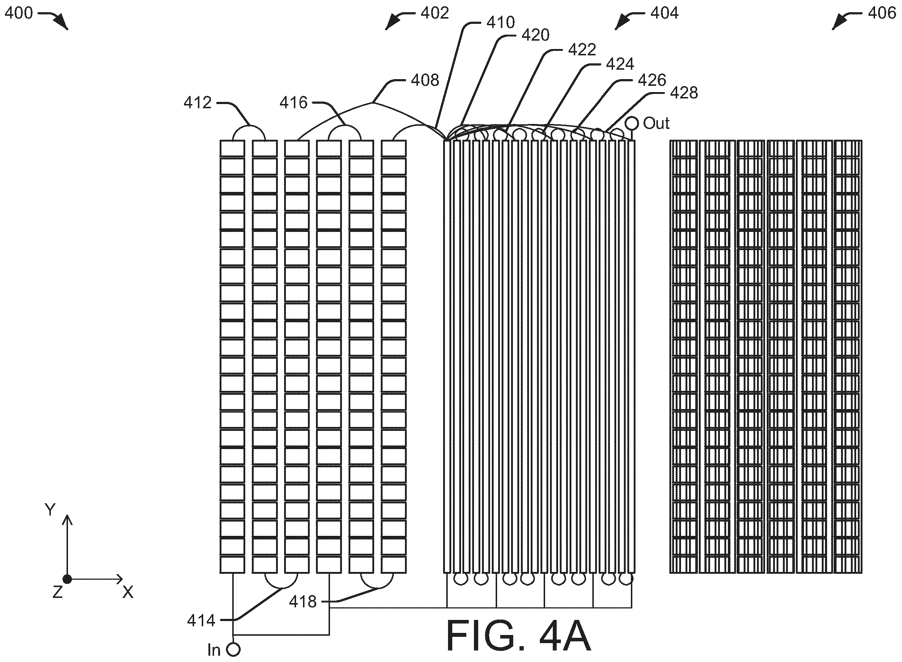

Figure 4A illustrates a schematic representation 400 of parallel sets of series connected groups of photovoltaic cells of a first module connected in parallel with parallel groups of series connected thin-film photovoltaic cells of a second module. Particular thin-film photovoltaic cell examples are described with respect to perovskite photovoltaic cells; however, it is to be appreciated that the particular examples apply to other thin-film photovoltaic cells as well. As shown, the schematic representation 400 includes parallel sets of groups of series connected photovoltaic cells 402 of the first module, parallel groups of series connected perovskite photovoltaic cells 404 of the second module, and a stacked module assembly 406 that includes the first module and the second module. In the stacked module assembly 406, the first module may be positioned below the second module such that photons which pass through the groups of perovskite photovoltaic cells 404 can be received by the groups of photovoltaic cells 402.

In one or more examples, a first module may include 144 half-cut M10 cells that includes two parallel sets of 72 series connected half-cut M10 cells that are connected in three groups. In certain embodiments, the sets of the 72 series connected half-cut M10 cells are electrically connected in parallel with the groups of the series connected perovskite photovoltaic cells 404 of the second module by a first parallel connection 408 (e.g., an external connection) and a second parallel connection 410.

In one example, the first set of the 72 series connected half-cut M10 cells include a first group (G1) of 24 series connected photovoltaic cells, a second group (G2) of 24 series connected photovoltaic cells, and a third group (G3) of 24 series connected photovoltaic cells that are connected by series connections 416 and 418 and the second set of 72 series connected half-cut M10 cells include a fourth group (G4) of 24 series connected photovoltaic cells, a fifth group (G5) of 24 series connected photovoltaic cells, and a sixth group (G6) of 24 series connected photovoltaic cells that are connected by series connections 412 and 414.

In one example, in which the 144 half-cut M10 cells having a surface area of about 165.3 square centimeters are shaded by the groups of perovskite photovoltaic cells 404 of the second module, each of the half-cut M10 cells generates about 0.711 V at Voc and about 0.592 V at maximum power (Vmp) at nominal operating cell temperature (NOCT). In this example, the groups of perovskite photovoltaic cells 404 include a glass layer with dimensions of about 1134 millimeters by 2382 millimeters. The glass layer may be common to the half-cut M10 cells included in the groups of photovoltaic cells 402 of the first module. In this example, the stacked module assembly 406 includes a 15 millimeter border without perovskite photovoltaic cells which is reserved for edge seal and results in a perovskite region having dimensions of about 1104 millimeters by 2352 millimeters. Although a 15 millimeter border is described, it is to be appreciated that, in some examples, the border reserved for edge seal can be less than 15 millimeters or greater than 15 millimeters. In one or more embodiments, each of the perovskite photovoltaic cells generates about 1.093 V at Voc and about 0.891 V at Vmp at NOCT. In these embodiments, the groups of perovskite photovoltaic cells 404 of the second module can voltage-match the groups of photovoltaic cells 402 of the first module with a perovskite photovoltaic cell having a desired width, such as a width of about 4.6 millimeters. For example, at a width of about 4.6 millimeters, 240 perovskite photovoltaic cells can voltage-match the groups of photovoltaic cells 402 of the first module and may be split into five parallel strings (groups) of 48 perovskite photovoltaic cells within the second module.

In one or more embodiments, a first group of 48 series connected perovskite photovoltaic cells is electrically connected in parallel with a node of other parallel groups of series connected perovskite photovoltaic cells 404 by a third parallel connection 420. In the illustrated example, a second group of 48 series connected perovskite photovoltaic cells is electrically connected in parallel with the node by a fourth parallel connection 422. Similarly, a third group of 48 series connected perovskite photovoltaic cells is electrically connected in parallel with the node by a fifth parallel connection 424; a fourth group of 48 series connected perovskite photovoltaic cells is electrically connected in parallel with the node by a sixth parallel connection 426; and a fifth group of 48 series connected perovskite photovoltaic cells is electrically connected in parallel with the node by a seventh parallel connection 428.

In some embodiments, N sets of M series connected photovoltaic cells may be electrically connected in parallel where N and M are integers and M is greater than N. In one or more examples, N may be 1, 2, 3, 4, 5, or an integer greater than 5. In various examples, M may be greater than 5, greater than 25, greater than 40, greater than 50, or greater than 100. In one or more embodiments, O groups of D series connected thin-film photovoltaic cells can be electrically connected in parallel where O and D are integers. In some examples, O may be 1, 2, 3, 4, 5, 6, 7, 8, 9 or an integer greater than 9. In one or more examples, D may be greater than 5, greater than 25, greater than 40, greater than 50, or greater than 100. In certain embodiments, the N sets are electrically connected in parallel with the O groups such as in the example described above in which N is 2, M is 72, O is 5, D is 48, and the N sets are connected in parallel with the O groups by the first, second, third, fourth, fifth, sixth, and seventh parallel connections 408, 410, 420, 422, 424, 426, 428. In general, an electrical conductor forms a first electrical path between a cathode end of the groups of photovoltaic cells 402 and a cathode end of the groups of perovskite photovoltaic cells 404 and a second electrical path between an anode end of the groups of photovoltaic cells 402 and an anode end of the groups of perovskite photovoltaic cells 404. The first electrical path and the second electrical path are configured to match a voltage generated at NOCT by the groups of photovoltaic cells 402 and the groups of perovskite photovoltaic cells 404.

Some embodiments of the disclosure include establishing a target output voltage for the stacked module assembly 406 based on limitations such as inverter system-level voltages and supply-side power requirements. The target output voltage limits a number of module assemblies (e.g., multiple instances of the stacked module assembly 406) that are connectable in series without exceeding an inverter system-level voltage (e.g., 1500 V). In various embodiments, a first target output voltage may maximize capacity (e.g., watts) at a cost of generated energy (e.g., watt-hours) while a second target output voltage may maximize generated energy (e.g., watt-hours) at a cost of capacity (e.g., watts). For example, the first target output voltage may be matched at Voc or Vmp at standard test conditions (STC) and the second target output voltage may be matched at Voc or Vmp at NOCT conditions. The supply-side power requirements can guide which of the first and second target output voltages should be established. For an electrical utility (i.e., an electric load-serving entity (LSE)) that experiences a peak demand during the day in the summer (e.g., driven by demand for powering air conditioning), the stacked module assembly 406 could contribute to generating capacity to meet the peak demand (plus a reserve margin) and the first target output voltage may be preferable relative to the second target output voltage. However, for an electrical utility that experiences a peak demand in the winter (e.g., driven by demand for powering heating which may be at night), the second target output voltage may be preferable relative to the first target output voltage.

After establishing the target output voltage for the stacked module assembly 406, dimensions of each of the photovoltaic cells and each of the thin-film photovoltaic cells can be computed based on the target output voltage. The dimensions of the photovoltaic cells are configured to generate a first voltage due to receiving electromagnetic radiation (e.g., light) at a first intensity (e.g., a first light intensity). The dimensions of the thin-film photovoltaic cells are configured to generate a second voltage due to receiving electromagnetic radiation at a second intensity, wherein the first intensity is received by the photovoltaic cells after a portion of the second intensity (e.g., about 50-67 percent of the full-sun intensity) is absorbed by the thin-film photovoltaic cells as the electromagnetic radiation passes through the thin-film photovoltaic cells. In some embodiments, the dimensions of the photovoltaic cells are computed based on at least one series electrical connection of the photovoltaic cells. In one or more embodiments, the dimensions of the thin-film photovoltaic cells are computed based on at least one series electrical connection of the thin-film photovoltaic cells. In various embodiments, the dimensions of the photovoltaic cells and the dimensions of the thin-film photovoltaic cells are computed based on at least one string of series connected photovoltaic cell that is connected in parallel with at least one string of series connected thin-film photovoltaic cells.

In one example, the stacked module assembly 406 generates about 52.4 V at Voc. In this example, the stacked module assembly 406 can generate about 16.26 A at Isc. Notably, at about 52.4 V at Voc about 28 stacked module assemblies 406 could be implemented in series (e.g., for AC power generation) even in scenarios in which inverter system-level voltages are limited to around 1500 V. In some examples, voltage matching may be preferable to current matching for power generation parameter matching. It has been observed that photovoltaic cells and perovskite photovoltaic cells degrade more quickly with respect to Isc than to Voc. Thus, over a 25-year panel life, Isc is likely to become mismatched at a faster rate than Voc.

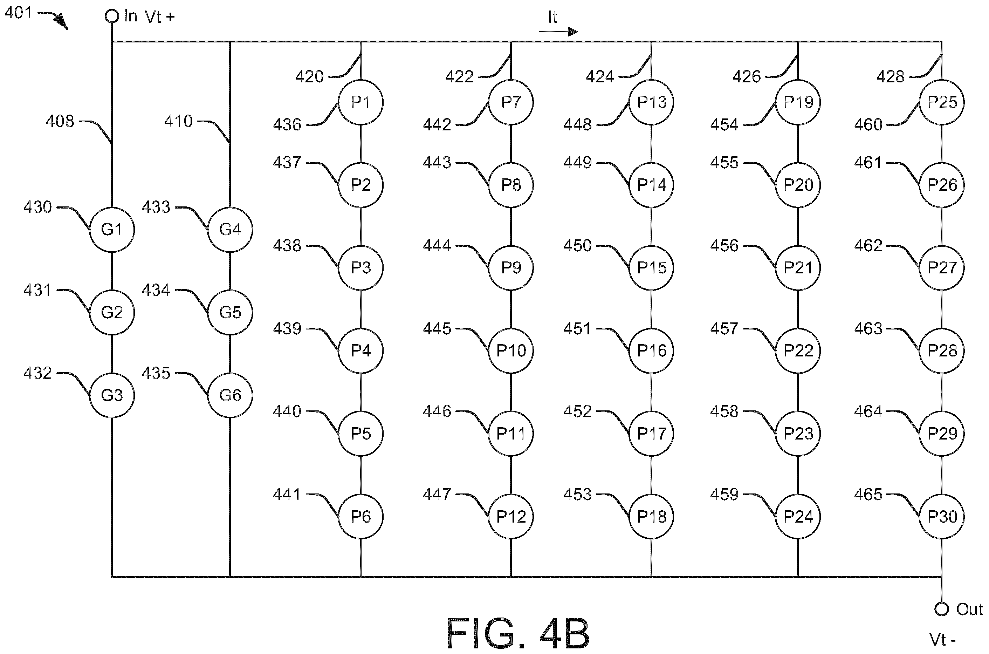

Figure 4B illustrates a third stacked module assembly schematic 401. The schematic 401 represents an equivalent circuit for the stacked module assembly 406. In one example, as shown, the first module includes a set of three groups 430-432 having 24 series connected photovoltaic cells each is connected in parallel with a set of three groups 433-435 having 24 series connected photovoltaic cells each. The set of the three groups 430-432 and the set of the three groups 433-435 are connected in parallel with five parallel groups of series connected perovskite photovoltaic cells 436-441; 442-447; 448-453; 454-459; 460-465 of the second module. In this example, as shown in Figure 4B, each group in the five groups 436-441; 442-447; 448-453; 454-459; 460-465 includes six series connected perovskite photovoltaic cells. In some cases, each group in the five groups 436-441; 442-447; 448-453; 454-459; 460-465 can include 5 or more, 10 or more, or 25 or more, or 50 or more, or 100 or more series connected perovskite photovoltaic cells.

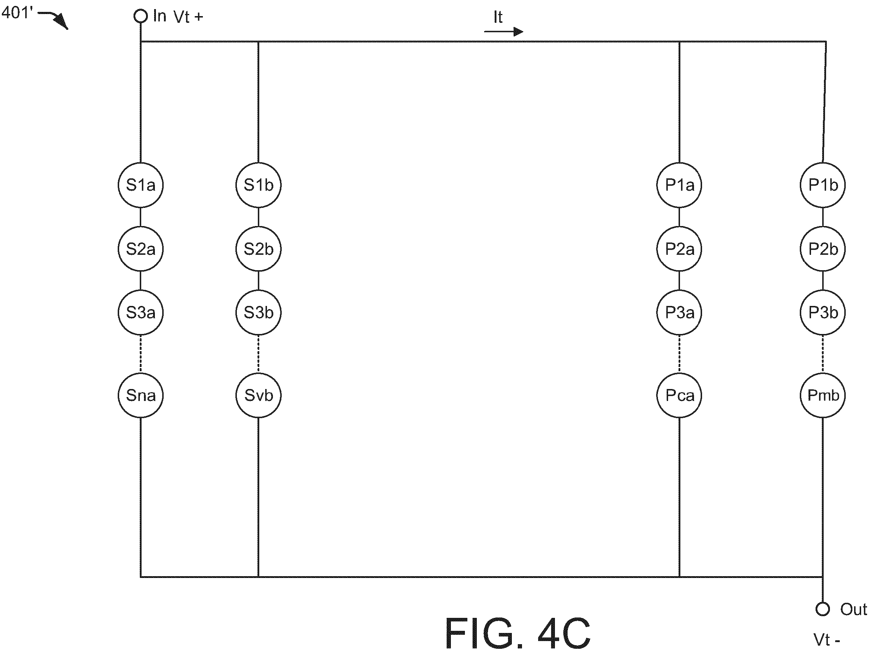

Figure 4C illustrates a generalized third stacked module assembly schematic 401', which can be useful to broadly describe possible variations in photovoltaic cell interconnection configurations, such as the configurations illustrated in Figures 4B, 5C and 6B, for example. A first module may include a group of cells "Sxa" connected in series, where "x" is a first integer corresponding to a first number of series connected S cells included in a parallel connected group of series connected photovoltaic cells included the first module, where x varies from 1 to n. The first module also may additionally include one or more second groups of cells "Syb" that are connected in series, where "y" is a second integer generally corresponding to a second number of series connected S cells included in the first module, where y varies from 1 to v. A second module can include a group of perovskite cells "Pza" connected in series where "z" is a third integer corresponding to a first number of series connected P cells included in each of the one or more parallel groups included the second module, where z varies from 1 to c. The second module may also additionally include one or more second groups of cells "Pwb" that are connected in series, where "w" is a fourth integer generally corresponding to a fourth number of series connected P cells included in the second module, where w varies from 1 to m. In one example, n and/or v may be 1, 2, 3, 4, 5, or an integer greater than 5, or an integer greater than 10 or an integer greater than 25, an integer greater than 40, an integer greater than 50, or an integer greater than 100. In various examples, c and/or m may be 1, 2, 3, 4, 5, or an integer greater than 5, greater than 25, greater than 40, greater than 50, or greater than 100.

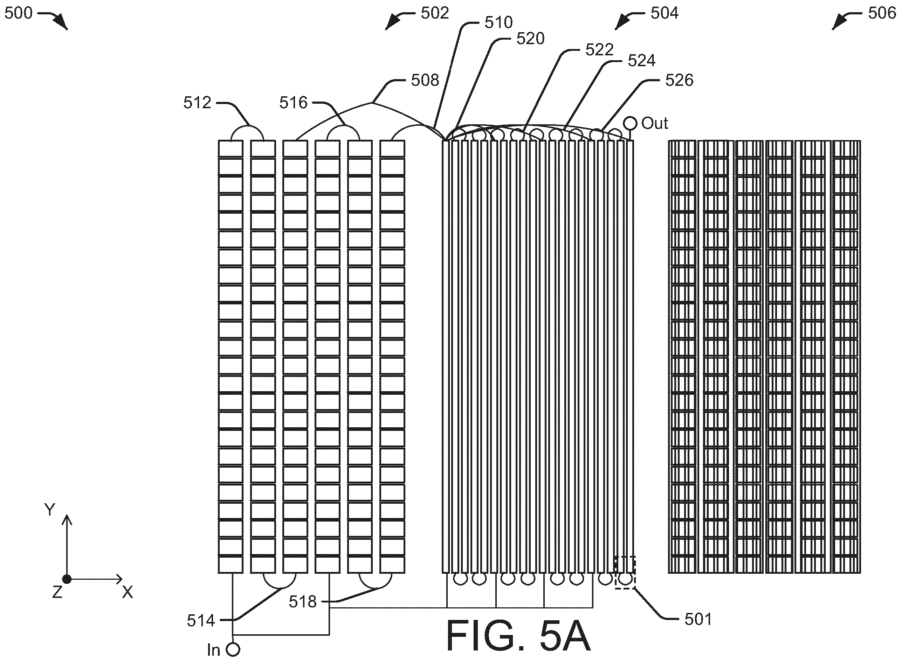

Figure 5A illustrates a schematic representation 500 of parallel sets of series connected groups of photovoltaic cells of a first module connected in parallel with parallel groups of series connected thin-film photovoltaic cells of a second module. Particular thin-film photovoltaic cell examples are described with respect to perovskite photovoltaic cells; however, it is to be appreciated that the particular examples apply to other thin-film photovoltaic cells as well. As shown in Figure 5A, the schematic representation 500 includes parallel sets of groups of series connected photovoltaic cells 502 of the first module, parallel groups of series connected perovskite photovoltaic cells 504 of the second module, and a stacked module assembly 506 that includes the first module and the second module. In the stacked module assembly 506, the first module may be positioned below the second module such that photons passing through the groups of perovskite photovoltaic cells 504 can be received by the groups of photovoltaic cells 502.

In one or more examples, the parallel sets of groups of photovoltaic cells 502 of the first module include the 144 series connected half-cut M10 cells in two parallel sets of 72 series connected half-cut M10 cells. In some embodiments, the first set of 72 series connected half-cut M10 cells is electrically connected in parallel with the parallel groups of series connected perovskite photovoltaic cells 504 of the second module by a first parallel connection 508. In certain embodiments, the second set of 72 series connected half-cut M10 cells is electrically connected in parallel with the groups of series connected perovskite photovoltaic cells 504 of the second module by a second parallel connection 510.

In some embodiments, the first set of 72 series connected half-cut M10 cells include the first group of 24 series connected photovoltaic cells, the second group of 24 series connected photovoltaic cells, and the third group of 24 series connected photovoltaic cells. In one or more embodiments, the first group of 24 series connected photovoltaic cells is electrically connected in series with the second group of 24 series connected photovoltaic cells by a first series connection 512. In various embodiments, the second group of 24 series connected photovoltaic cells is electrically connected in series with the third group of 24 series connected photovoltaic cells by a second series connection 514.

In one or more embodiments, the second set of 72 series connected half-cut M10 cells include the fourth group of 24 series connected photovoltaic cells, the fifth group of 24 series connected photovoltaic cells, and the sixth group of 24 series connected photovoltaic cells. In some embodiments, the fourth group of 24 series connected photovoltaic cells is electrically connected in series with the fifth group of 24 series connected photovoltaic cells by a third series connection 516. In certain embodiments, the fifth group of 24 series connected photovoltaic cells is electrically connected in series with the sixth group of 24 series connected photovoltaic cells by a fourth series connection 518.

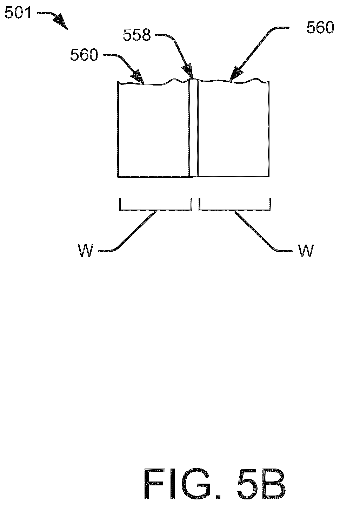

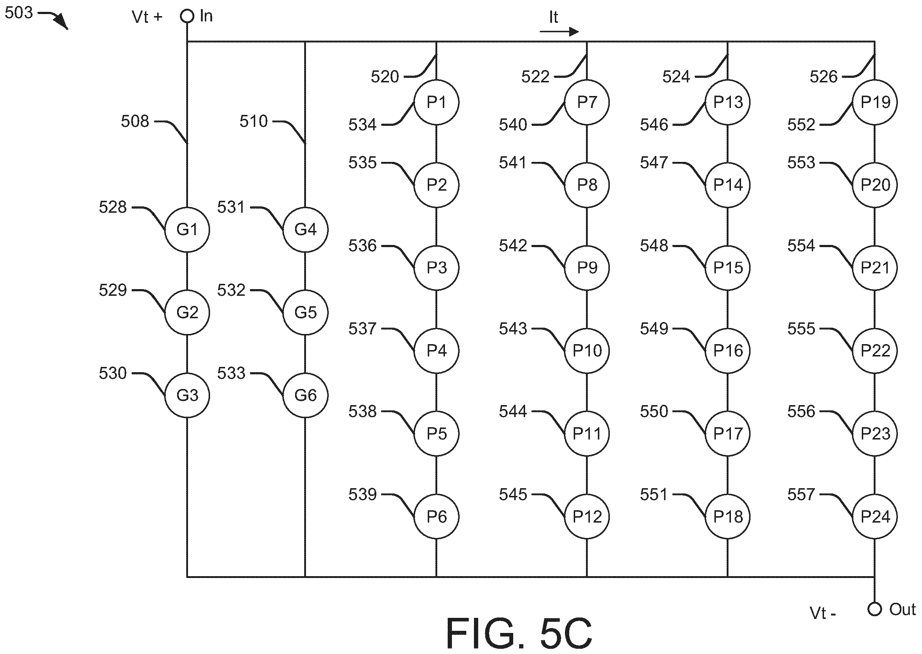

Figure 5B illustrates a representation 501 of perovskite photovoltaic cells 560 (e.g., cells P1 and P2 in Figure 5C) having a width "W" that is adjoined by a scribed region 558. The scribe lines disposed within the scribe region 558, as will be discussed further below, will include scribe lines (e.g., scribe lines P3, P2, and P1 in scribed region 718-1) that are configured to enable the series connections between the perovskite photovoltaic cells 560. The representation 501 illustrates portions of two of the perovskite photovoltaic cells as indicated in Figure 5A and 5C. In order to reduce the number of parallel strings of perovskite photovoltaic cells included in the parallel groups of series connected perovskite photovoltaic cells 504, the parallel groups of series connected perovskite photovoltaic cells can include perovskite photovoltaic cells having a width "W" in the series connection direction greater than about 4.6 millimeters. In one or more embodiments, the parallel sets of the groups of series connected perovskite photovoltaic cells 504 may voltage-match the parallel sets of the groups of series connected photovoltaic cells 502 with perovskite photovoltaic cells having a width "W" of about 5.75 millimeters. In various embodiments, by increasing the perovskite photovoltaic cell width "W" in the series connection direction from about 4.6 millimeters to about 5.75 millimeters, the parallel groups of series connected perovskite photovoltaic cells 504 can voltage-match the parallel sets of the groups of series connected photovoltaic cells 502 using, for example, 192 perovskite photovoltaic cells split into four parallel strings/sets of 48 series connected perovskite photovoltaic cells.

In one example, a first group of 48 series connected perovskite photovoltaic cells are electrically connected in parallel with a node of the parallel sets of the groups of series connected perovskite photovoltaic cells 504 by a third parallel connection 520. In the illustrated example, a second group of 48 series connected perovskite photovoltaic cells is electrically connected in parallel with the node by a fourth parallel connection 522. In certain embodiments, a third group of 48 series connected perovskite photovoltaic cells is electrically connected in parallel with the node by a fifth parallel connection 524. In one example, a fourth group of 48 series connected perovskite photovoltaic cells is electrically connected in parallel with the node by a sixth parallel connection 526.

In various embodiments, N sets of M series connected photovoltaic cells may be electrically connected in parallel where N and M are integers and M is greater than N. In some examples, N may be 1, 2, 3, 4, 5, or an integer greater than 5. In one or more examples, M may be greater than 5, greater than 25, greater than 40, greater than 50, or greater than 100. In some embodiments, O groups of D series connected thin-film photovoltaic cells can be electrically connected in parallel where O and D are integers. In some examples, O may be 1, 2, 3, 4, 5, 6, 7, 8, 9 or an integer greater than 9. In one or more examples, D may be greater than 5, greater than 25, greater than 40, greater than 50, or greater than 100. In certain embodiments, the N sets are electrically connected in parallel with the O groups such as in the example described above in which N is 2, M is 72, O is 4, D is 48, and the N sets are connected in parallel with the O groups by the first, second, third, fourth, fifth, and sixth parallel connections 508, 510, 520, 522, 524, 526.

Some embodiments of the disclosure include connecting a plurality of series connected photovoltaic cells, which are configured to generate a first voltage due to receiving electromagnetic radiation (e.g., light) at a first intensity (e.g., a first light intensity), to a plurality of series connected thin-film photovoltaic cells, which are configured to generate a second voltage due to receiving electromagnetic radiation at a second intensity, wherein the first intensity is received by the plurality of series connected photovoltaic cells after a portion of the second intensity is absorbed by the plurality of series connected thin-film photovoltaic cells as the electromagnetic radiation passes through the plurality of series connected thin-film photovoltaic cells, and the thin-film photovoltaic cells each have a width "W" in the series connection direction so as to allow the first voltage to match the second voltage. In other words, by adjusting the thin-film photovoltaic cell width "W" during the manufacturing process (e.g., scribe line spacing) to match a known or estimated voltage generated by the stacked module assembly 406, the stacked module assembly 506 can be adjusted to generate the same or similar electrical generation outputs as the stacked module assembly 406.

Like the stacked module assembly 406, the stacked module assembly 506 generates about 52.4 V at Voc. In some embodiments, the stacked module assembly 506 generates about 16.26 A at Isc. By increasing the thin-film photovoltaic cell width "W" during manufacturing (e.g., scribe line spacing) to match a known or estimated voltage generated by the stacked module assembly 406, the stacked module assembly 506 will have the same or similar electrical generation outputs as the stacked module assembly 406 without the seventh parallel connection 428 and with 48 fewer thin-film photovoltaic cells and corresponding electrical connections within the second module.

Figure 5C illustrates a fourth stacked module assembly schematic 503. The schematic 503 represents an equivalent circuit for the stacked module assembly 506. In this example, the first module includes a first set of three groups 528-530 of series connected photovoltaic cells, which include multiple (e.g., 24 photo voltaic cells) series connected photovoltaic cells, that is connected in parallel with a second set of three groups 531-533 of series connected photovoltaic cells, which also include multiple (e.g., 24 photo voltaic cells) series connected photovoltaic cells. The first set of the three groups 528-530 and the second set of the three groups 531-533 are connected in parallel with four parallel groups 534-539, 540-545, 546-551, and 552-557 of series connected perovskite photovoltaic cells of the second module. Each group in the four parallel groups 534-539, 540-545, 546-551, and 552-557 of series connected photovoltaic cells each include multiple series connected photovoltaic cells, such as six series connected perovskite photovoltaic cells.

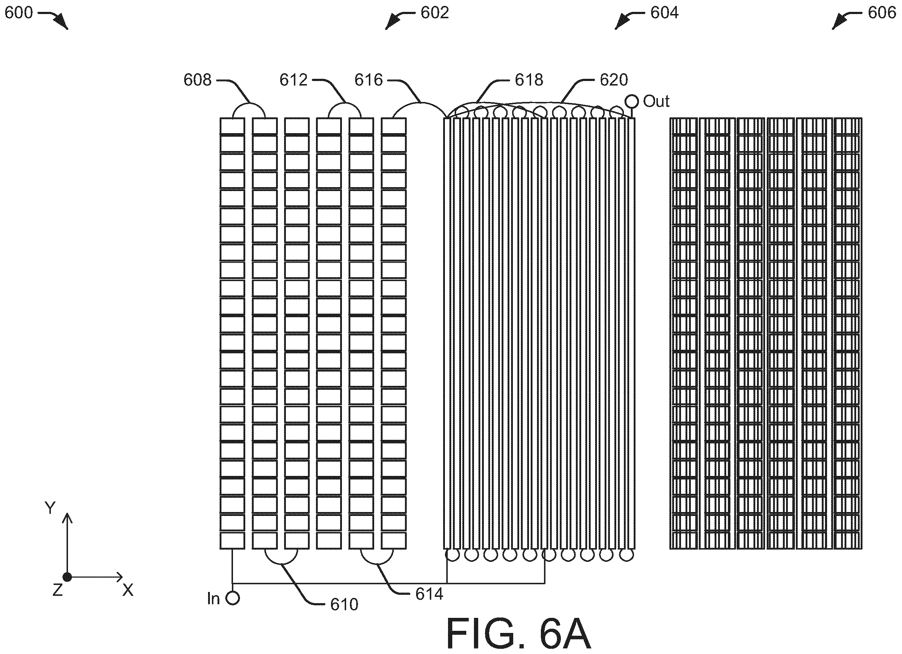

Figure 6A illustrates a schematic representation 600 of groups of series connected photovoltaic cells of a first module connected in parallel with parallel sets of groups of series connected thin-film photovoltaic cells of a second module. Particular thin-film photovoltaic cell examples are described with respect to perovskite photovoltaic cells; however, it is to be appreciated that the particular examples apply to other thin-film photovoltaic cells as well. As shown, the schematic representation 600 includes groups of series connected photovoltaic cells 602 of the first module, parallel sets of groups of series connected perovskite photovoltaic cells 604 of the second module, and a stacked module assembly 606 that includes the first module and the second module. In some embodiments, in the stacked module assembly 606, the first module is disposed below the second module such that photons which pass through the groups of perovskite photovoltaic cells 604 can be received by the groups of photovoltaic cells 602.

In one example, the groups of series connected photovoltaic cells 602 include 144 half-cut M10 cells in a single set of series connected photovoltaic cells. As shown, the groups of series connected photovoltaic cells 602 include a first group of 24 series connected photovoltaic cells electrically connected in series with a second group of 24 series connected photovoltaic cells by a first series connection 608. In this example, the second group of 24 series connected photovoltaic cells is electrically connected in series with a third group of 24 series connected photovoltaic cells by a second series connection 610; a fourth group of 24 series connected photovoltaic cells is electrically connected in series with a fifth group of 24 series connected photovoltaic cells by a third series connection 612; the fifth group of 24 series connected photovoltaic cells is electrically connected in series with a sixth group of 24 series connected photovoltaic cells by a fourth series connection 614. In this example, the stacked module assembly 606 also includes parallel the groups of series connected perovskite photovoltaic cells, wherein the series connected perovskite photovoltaic cells 604 include 192 perovskite photovoltaic cells that are connected in two parallel groups of 96 series connected perovskite photovoltaic cells.

The sixth group of 24 series connected photovoltaic cells is electrically connected in parallel to a node of the parallel groups of series connected perovskite photovoltaic cells 604 by a first parallel connection 616. In one or more embodiments, the first group of 96 series connected perovskite photovoltaic cells is electrically connected in parallel to the node by a second parallel connection 618. The second group of 96 series connected perovskite photovoltaic cells is electrically connected in parallel to the node by a third parallel connection 620.

In some embodiments, N sets of M series connected photovoltaic cells may be electrically connected in parallel where N and M are integers and M is greater than N. In one or more examples, N may be 1, 2, 3, 4, 5, or an integer greater than 5. In various examples, M may be greater than 5, greater than 25, greater than 40, greater than 50, or greater than 100. In one or more embodiments, O groups of D series connected thin-film photovoltaic cells can be electrically connected in parallel, where O and D are integers. In some embodiments, O may be 1, 2, 3, 4, 5, 6, 7, 8, 9 or an integer greater than 9. In some embodiments, D may be greater than 5, greater than 25, greater than 40, greater than 50, or greater than 100. In various embodiments, the N sets are electrically connected in parallel with the O groups, such as in the example described above in which N is 1, M is 144, O is 2, D is 96, and the N sets are connected in parallel with the O groups by the first, second, and third parallel connections 616, 618, 620.

Some embodiments of the disclosure include establishing a target output voltage for the stacked module assembly 606 based on various limitations such as inverter system-level voltages and supply-side power/energy requirements. For instance, the target output voltage generally limits a number of module assemblies (e.g., multiple instances of the stacked module assembly 606) that are connectable in series without exceeding an inverter system-level voltage. In various embodiments, a first target output voltage at maximize capacity at a cost of generated energy while a second target output voltage may maximize generated energy at a cost of capacity. For example, the first target output voltage may be matched at Voc or Vmp at STC and the second target output voltage may be matched at Voc or Vmp at NOCT conditions. In one or more examples, the supply-side power requirements provide guidance with respect to which of the first and second target output voltages should be established. For a first electrical utility that experiences a peak demand during the day in the summer (e.g., driven by demand for powering air conditioning), the stacked module assembly 606 may contribute to meeting the peak demand (e.g., and a reserve margin) and the first target output voltage may be preferable relative to the second target output voltage. However, for a second electrical utility that experiences a peak demand in the winter (e.g., driven by demand for powering heating), the second target output voltage may be preferable relative to the first target output voltage.

After establishing the target output voltage for the stacked module assembly 606, dimensions of each of the photovoltaic cells and each of the thin-film photovoltaic cells can be computed based on the target output voltage. The dimensions of the photovoltaic cells are configured to generate a first voltage due to receiving electromagnetic radiation (e.g., light) at a first intensity (e.g., a first light intensity). The dimensions of the thin-film photovoltaic cells are configured to generate a second voltage due to receiving electromagnetic radiation at a second intensity, wherein the first intensity is received by the photovoltaic cells after a portion of the second intensity (e.g., about 50-67 percent of the full-sun intensity) is absorbed by the thin-film photovoltaic cells as the electromagnetic radiation passes through the thin-film photovoltaic cells. In various embodiments, the dimensions of the photovoltaic cells are computed based on at least one series electrical connection of the photovoltaic cells. In some, the dimensions of the thin-film photovoltaic cells are computed based on at least one series electrical connection of the thin-film photovoltaic cells. In one or more embodiments, the dimensions of the photovoltaic cells and the dimensions of the thin-film photovoltaic cells are computed based on at least one parallel electrical connection of the at least one series electrical connection of the photovoltaic cells with the at least one series connection of the thin-film photovoltaic cells.

The groups of series connected photovoltaic cells 602 of the first module generate about 85.25 V at Vmp at NOCT and the parallel sets of the groups of perovskite photovoltaic cells 604 of the second module generate about 85.5 V at Vmp at NOCT in some examples. Notably, the Vmp is less than 100 V. In various embodiments, the stacked module assembly 606 generates about 104.9 V at Voc. In some examples, the stacked module assembly 606 generates about 8.13 A at Isc.

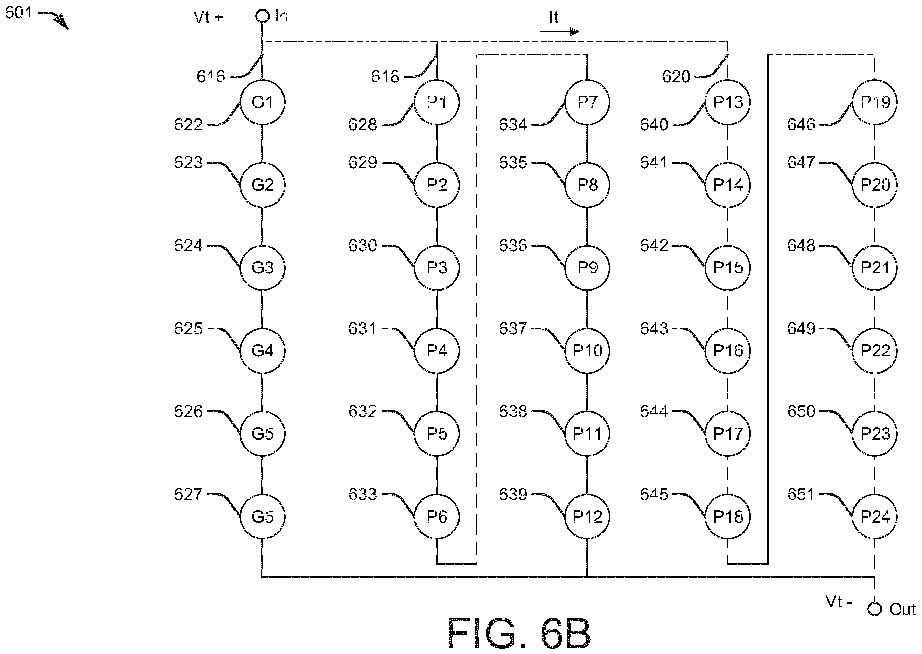

Figure 6B illustrates a fifth stacked module assembly schematic 601. The schematic 601 represents an equivalent circuit for the stacked module assembly 606. As shown, the first module includes a set of six groups 622-627, which each include 24 series connected photovoltaic cells. In this example, each of the of six groups 622-627 of series connected photovoltaic cells are connected in parallel with a first group of 12 series connected perovskite photovoltaic cells 628-639 and a second group of 12 series connected perovskite photovoltaic cells 640-651. In this simplified example, the second module includes 24 series connected perovskite photovoltaic cells. However, in some other examples, the photovoltaic cells may include greater than 5 photovoltaic cells, or greater than 10 photovoltaic cells, or greater than 25 photovoltaic cells, or greater than 40 photovoltaic cells, or greater than 50 photovoltaic cells, or greater than 100 photovoltaic cells, while the thin-film photovoltaic cells (e.g., perovskite photovoltaic cells) may include greater than 5 thin-film photovoltaic cells, or greater than 10 thin-film photovoltaic cells, or greater than 25 thin-film photovoltaic cells, or greater than 40 thin-film photovoltaic cells, or greater than 50 thin-film photovoltaic cells, or greater than 100 thin-film photovoltaic cells.

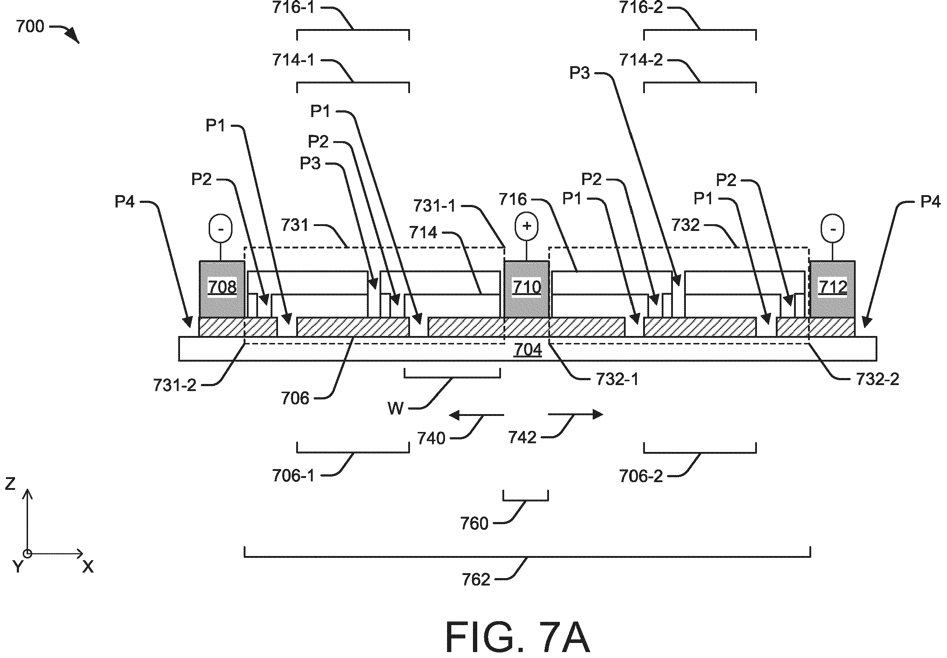

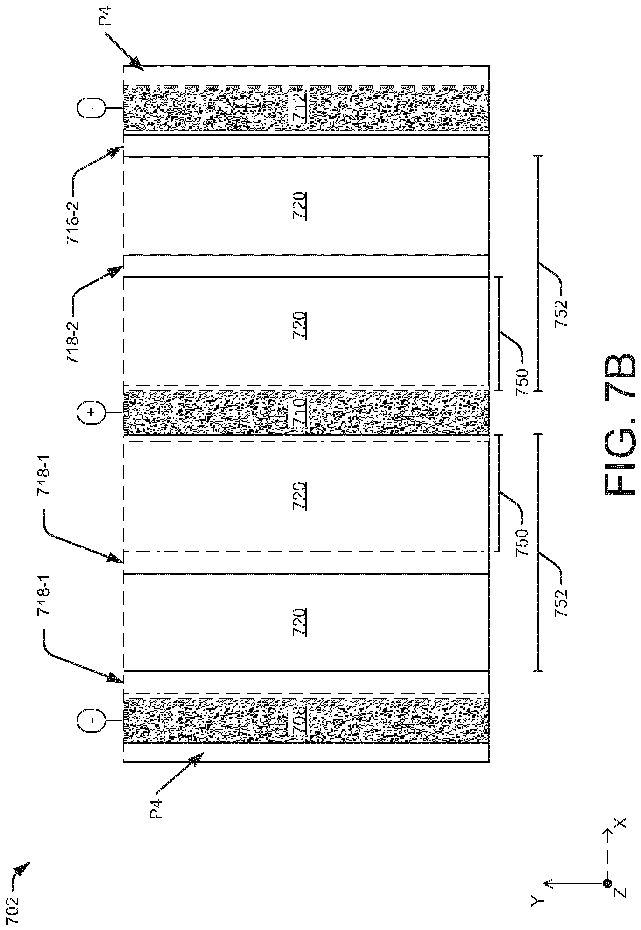

Figure 7A illustrates a schematic side view 700 of a first thin-film photovoltaic module that includes a plurality of serially connected thin-film photovoltaic cells that can be used to form a portion of a first circuit. Figure 7B illustrates a plan view 702 of the first thin-film photovoltaic module illustrated in Figure 7A. Particular thin-film photovoltaic cell examples are described with respect to perovskite photovoltaic cells; however, it is to be appreciated that the particular examples apply to other thin-film photovoltaic cells as well. In some embodiments, the first thin-film photovoltaic module can include thin-film photovoltaic cells (e.g., perovskite photovoltaic cells) and a second photovoltaic module can include photovoltaic cells (e.g., photovoltaic cells of a crystalline material, monocrystalline silicon photovoltaic cells, polycrystalline silicon photovoltaic cells, thin-film photovoltaic cells, etc.). In some embodiments, a thin-film photovoltaic module (e.g., including perovskite photovoltaic cells) and a photovoltaic module are positioned in a stacked configuration. The first thin-film photovoltaic module includes a superstrate 704 (e.g., a substrate) which is optically transparent such that electromagnetic radiation (e.g., light) passes through the superstrate 704 and can be received by photovoltaic cells (not shown) disposed below the superstrate 704. First scribe lines P1, second scribe lines P2, third scribe lines P3, and fourth scribe lines P4 of the first thin-film photovoltaic module are illustrated in Figure 7A. A set of scribe lines, which includes a first scribe line P1, a second scribe line P2, and a third scribe line P3, generally defines each of the serially connected thin-film photovoltaic cells of the first thin-film photovoltaic module.

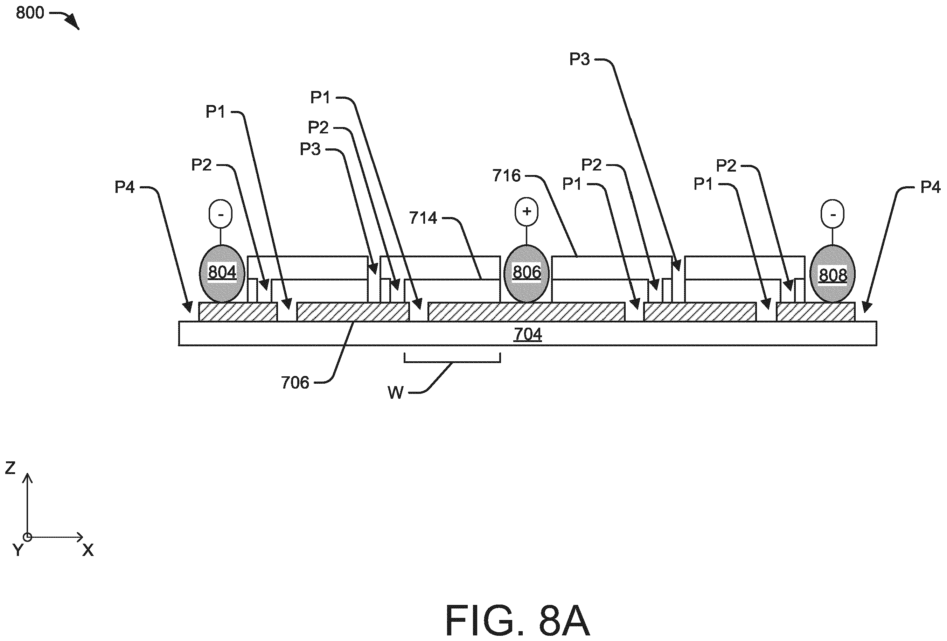

In some embodiments, a first contact layer 706 is disposed above the superstrate 704, an absorber layer 714 is at least partially disposed above the first contact layer 706, and a second contact layer 716 is at least partially disposed above the absorber layer 714. In one or more embodiments, the absorber layer 714 includes a perovskite containing absorber layer. In one example, the absorber layer includes a perovskite material that has the stoichiometry of ABX₃, where A is a first cation, B is a second cation, and X comprises at least one halide (e.g., chloride, bromide, or iodide). In another example, the absorber layer 140 includes a perovskite that has a stoichiometry of ABX₃, where A comprises at least one of formamidinium (FA), methylammonium (MA), or cesium, and B comprises at least one of tin or lead, and X comprises at least one halide, methylammonium lead tri-iodide (MAPbl3), cesium formamidinium methylammonium lead tri-iodide (CsFAMAPbl3), silicon (amorphous and/or crystalline), Group III-V materials (amorphous and/or crystalline), organic photovoltaic materials (OPV), dye-sensitized PV cells (DSSX), copper indium gallium selenide (CIGS), cadmium telluride (CdTe), or combinations thereof. While the perovskite photovoltaic cells illustrated in Figures 7A and 8A include an illustration of a simplified structure of a group of series connected perovskite photovoltaic cells this configurations are not intended to be limiting as to the scope of the disclosure provided herein. For example, the perovskite photovoltaic cells can also include one or more charge transport layers (CTL) that are each disposed on opposing sides of the absorber layer 714 and/or one or more barrier layers that are disposed within the device layer stack without deviating from the scope of the disclosure provided herein.

The first thin-film photovoltaic module includes a first electrode 708, a second electrode 710 (e.g., a common electrode), and a third electrode 712. In some embodiments, at least one of the first, second, and third electrodes 708, 710, 712 includes a flat ribbon of an electrically conductive material. In one or more embodiments, the second electrode 710 includes a flat ribbon of an electrically conductive material that is disposed on/above the first contact layer 706. In various embodiments, the second electrode 710 includes a flat ribbon of an electrically conductive material that is disposed between the absorber layer 714 (e.g., that includes the perovskite containing absorber layer) and the second contact layer 716. In certain embodiments, one or more dimensions of the first, second, and third electrodes 708, 710, 712 are minimized such in order to maximize electromagnetic radiation (e.g., light) transmission through the superstrate 704. In various embodiments, the first, second, and third electrodes 708, 710, 712 are manufactured from optically transparent electrical conductor materials such as indium tin oxide, silver nanowires, graphene, etc.

In the illustrated example, the second electrode 710 is disposed between the first electrode 708 and the third electrode 712. In some embodiments, the second electrode 710 is a common electrode to the first and second electrodes 708, 712. In one or more embodiments, the first electrode 708 and the second electrode 710 form a first circuit and the second electrode 710 and the third electrode 712 form a second circuit. In some examples, the first electrode 708 and the third electrode 712 have a first polarity and the second electrode 710 has a second polarity. In various embodiments, the second electrode 710 can include any of the first parallel connection 408, the second parallel connection 410, the third parallel connection 420, the fourth parallel connection 422, the fifth parallel connection 424, the sixth parallel connection 426, the seventh parallel connection 428, the first parallel connection 508, the second parallel connection 510, the third parallel connection 520, the fourth parallel connection 522, the fifth parallel connection 524, the sixth parallel connection 526, the first parallel connection 616, the second parallel connection 618, or the third parallel connection 620.

Although the second electrode 710 is a common electrode to the first and second electrodes 708, 712 in the examples above, it is to be appreciated that, in other examples, the first electrode 708 or the second electrode is implemented as a common electrode. In some embodiments, the first electrode 708 is a common electrode to the second electrode 710 and the third electrode. In other embodiments, the third electrode 712 is a common electrode to the first electrode 708 and the second electrode 710.

As shown in the plan view 702 (Figure 7B), the first thin-film photovoltaic module includes scribed regions 718-1, 718-2 and photovoltaic cell active regions 720. In some embodiments, a relative order of scribe lines in the scribed regions 718-1 (e.g., P3, P2, P1) is different than a relative order of scribe lines in the scribed regions 718-2 (e.g., P1, P2, P3). For example, the relative order of the 718-1 (e.g., P3, P2, P1) mirrors the relative order of the 718-2 (e.g., P1, P2, P3) relative to the second electrode 710. In these embodiments, the different relative order of scribe lines in the scribed regions 718-1, 718-2 facilitates elimination of an electrode in the first thin-film photovoltaic module such that the second electrode 710 is common to the first electrode 708 and the third electrode 712. Generally, first scribe lines may be formed in a first scribe region on a first side of an electrode disposed between a pair of electrodes and the first scribe lines can have a first order relative to the electrode. In some examples, second scribe lines may be formed in a second scribe region on a second side of the electrode and the second scribe lines may have a second order relative to the electrode that mirrors the first order. Generally, a first scribe line of a first particular type may be formed on a first side of an electrode such that the first scribe line is disposed a first particular distance 750 from the electrode on the first side. In some examples, a second scribe line of the first particular type may be formed on a second side of the electrode such that the second scribe line is disposed the first particular distance 750 from the electrode on the second side. In various examples, a third scribe line of a second particular type may be formed on the first side of the electrode such that the third scribe line is disposed a second particular distance 752 from the electrode on the first side. A fourth scribe line of the second particular type may be formed on the second side of the electrode such that the fourth scribe line is disposed the second particular distance 752 from the electrode on the second side. In this configuration, the series connected perovskite photovoltaic cells formed between the first electrode 708 and the second electrode 710 can be connected in parallel with the series connected perovskite photovoltaic cells formed between the second electrode 710 and the third electrode 712. The elimination of the electrode reduces optical losses (e.g., geometric fill factor losses) for the first thin-film photovoltaic module.

In some embodiments, as illustrated in Figures 7A-7B, a first plurality of photovoltaic cells 731 can be serially electrically connected in a first direction 740 between the first electrode 708 and the second electrode 710. In one or more embodiments, a second plurality of photovoltaic cells 732 can be serially electrically connected in a second direction 742 between the second electrode 710 and the third electrode 712. In various examples, the second direction 742 is opposite to the first direction 740. In one example, the first plurality of photovoltaic cells 731 can be serially electrically connected by defining and assigning the order of scribe lines (e.g., P1, P2, P3) formed in each of the serially connected photovoltaic cells within the scribed regions 718-1 in a first direction 740 and the second plurality of photovoltaic cells 732 can be serially electrically connected by defining and assigning the order of scribe lines (e.g., P1, P2, P3) formed in each of the serially connected photovoltaic cells within the scribed regions 718-2 in a second direction 742. In this example, an anode end 731-1 of the serially electrically connected first plurality of photovoltaic cells 731 and an anode end 732-1 of the serially electrically connected second plurality of photovoltaic cells 732 can be electrically coupled to second electrode 710. In some examples, the second electrode 710 can include an anodic electrode. A cathode end 731-2 of the serially connected first plurality of photovoltaic cells 731 can be coupled to the first electrode 708 and a cathode end 732-2 of the serially connected second plurality of photovoltaic cells 732 can be coupled to the third electrode 712. In one or more examples, the first electrode 708 may include a first cathodic electrode and the third electrode 712 may include a second cathodic electrode.

In various embodiments, the anode end 731-1 of the first plurality of photovoltaic cells 731 is disposed a first distance 760 from the anode end 732-1 of the second plurality of photovoltaic cells 732. The cathode end 731-2 of the first plurality of photovoltaic cells 731 is disposed a second distance 762 from the cathode end 732-2 of the second plurality of photovoltaic cells 732. In the example illustrated in Figure 7A, the second distance 762 is greater than the first distance 760.

In some embodiments, at least one photovoltaic cell of the first plurality of photovoltaic cells 731 includes a first portion 706-1 of the first contact layer 706 disposed over a surface of the superstrate 704, a first portion 714-1 of the absorber layer 714 disposed over the first portion 706-1 of the first contact layer 706, and a first portion 716-1 of the second contact layer 716 disposed over the first portion 714-1 of the absorber layer 714. In various embodiments, the first portion 706-1 of the first contact layer 706 is disposed between first P1 scribe lines. A first P2 scribe line may be formed though the first portion 714-1 of the absorber layer 714. In some examples, a first P3 scribe line extends through the first portion 716-1 of the second contact layer 716 and the first portion 714-1 of the absorber layer 714. In certain embodiments, the first P1 scribe lines, the first P2 scribe line, and the first P3 scribe line are serially positioned in the first direction 740 that is parallel to the surface of the superstrate 704.

In one or more embodiments, at least one photovoltaic cell of the second plurality of photovoltaic cells 732 includes a second portion 706-2 of the first contact layer 706 disposed over the surface of the superstrate 704, a second portion 714-2 of the absorber layer 714 disposed over the second portion 706-2 of the first contact layer 706, and a second portion 716-2 of the second contact layer 716 disposed over the second portion 714-2 of the absorber layer 714. In some embodiments, the second portion 706-2 of the first contact layer 706 is disposed between second P1 scribe lines. A second P2 scribe line can be formed though the second portion 714-2 of the absorber layer 714. In one or more examples, a second P3 scribe line extends through the second portion 716-2 of the second contact layer 716 and the second portion 714-2 of the absorber layer 714. In various embodiments, the second P1 scribe lines, the second P2 scribe line, and the second P3 scribe line are serially positioned in the second direction 742 that is parallel to the surface of the superstrate 704 and opposite to the first direction 740.

Some embodiments of the disclosure include establishing a target output voltage for a photovoltaic device that includes thin-film photovoltaic modules and photovoltaic modules in a stacked configuration based on various limitations such as inverter system-level voltages and supply-side power/energy requirements. In one or more embodiments, after the target output voltage is for the photovoltaic device, then dimensions of thin-film photovoltaic cells included in the thin-film photovoltaic modules and dimensions of photovoltaic cells included in the photovoltaic modules are computed based on the target output voltage. In some examples, dimensions of electrodes are minimized based on the dimensions of the thin-film photovoltaic cells and the photovoltaic cells. Accordingly, computing dimensions of the thin-film photovoltaic cells and the photovoltaic cells as described above can include minimizing a surface area of electrodes (e.g., the first, second, and third electrodes 708, 710, 712), and updating the first electromagnetic radiation intensity received by the photovoltaic cells and the second electromagnetic radiation intensity received by the thin-film photovoltaic cells based on the minimized surface area of the electrodes. In some embodiments, a change in the first voltage generated by the photovoltaic cells is estimated based on the updated first electromagnetic radiation intensity and a change in the second voltage generated by the thin-film photovoltaic cells based on the updated second electromagnetic radiation intensity is also estimated. In various embodiments, the dimensions of the photovoltaic cells are recomputed based on the estimated change in the first voltage and the dimensions of thin-film photovoltaic cells are recomputed based on the estimated change in the second voltage.

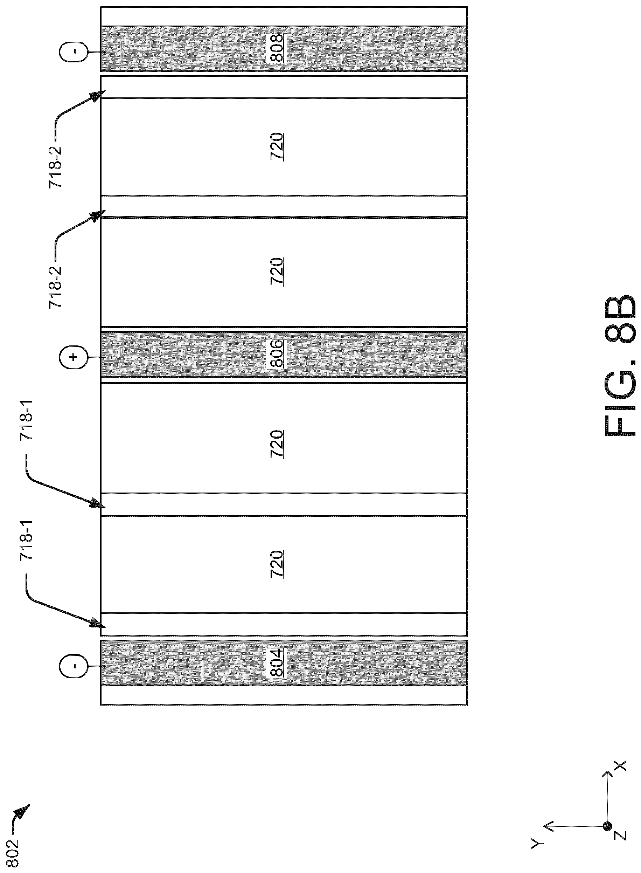

Figure 8A illustrates a schematic side view 800 of a second thin-film photovoltaic module. Figure 8B illustrates a plan view 802 of the second thin-film photovoltaic module illustrated in Figure 8A. Particular thin-film photovoltaic cell examples are described with respect to perovskite photovoltaic cells; however, it is to be appreciated that the particular examples apply to other thin-film photovoltaic cells as well. In some embodiments, the second thin-film photovoltaic module is similar to the first thin-film photovoltaic module illustrated in Figures 7A-7B but additionally includes a first shaped electrode 804, a second shaped electrode 806, and a third shaped electrode 808. In one or more embodiments, the first, second, and third shaped electrodes 804, 806, 808 include shaped wires having cross-sections that are circular, triangular, hemispherical, etc. In various embodiments, the first, second, and third shaped electrodes 804, 806, 808 have a lateral dimension (e.g., X-direction dimension) that is configured to maximize light transmission through the superstrate 704 by minimizing transmission losses to an adjacently positioned group of photovoltaic cells (e.g., photovoltaic cells 402, 502, 602) due to shadowing. In certain embodiments, the first, second, and third shaped electrodes 804, 806, 808 include shapes/dimensions configured to maximize electrical conductivity. In the example illustrated in the side view 800, the first, second, and third shaped electrodes 804, 806, 808 have a same cross-sectional shape; however, in other examples, the first, second, and third shaped electrodes 804, 806, 808 may not have the same cross-sectional shape. In some embodiments, the first, second, and third shaped electrodes 804, 806, 808 can each have a unique cross-sectional shape. For example, the second shaped electrode 806 includes a wire having a first cross-sectional shape and the first shaped electrode 804 includes a wire having a second cross-sectional shape that is different from the first cross-sectional shape. In one or more embodiments, the second shaped electrode 806 includes an anodic electrode, the first shaped electrode 804 includes a first cathodic electrode, and the third shaped electrode 808 includes a second cathodic electrode. The first cathodic electrode included in the first shaped electrode 804 may have a first cross-sectional shape and the second cathodic electrode included in the third shaped electrode 808 may have a second cross-sectional shape that is different from the first cross-sectional shape.

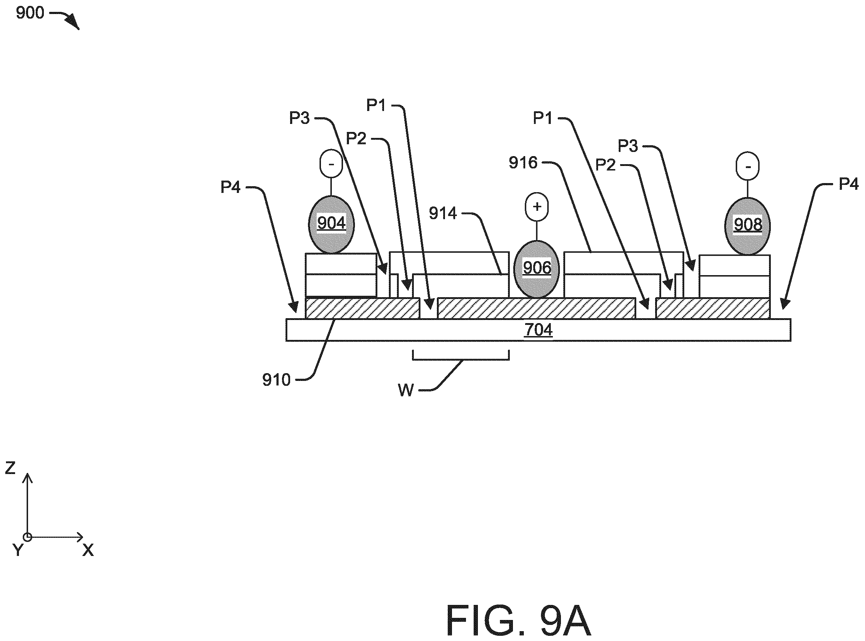

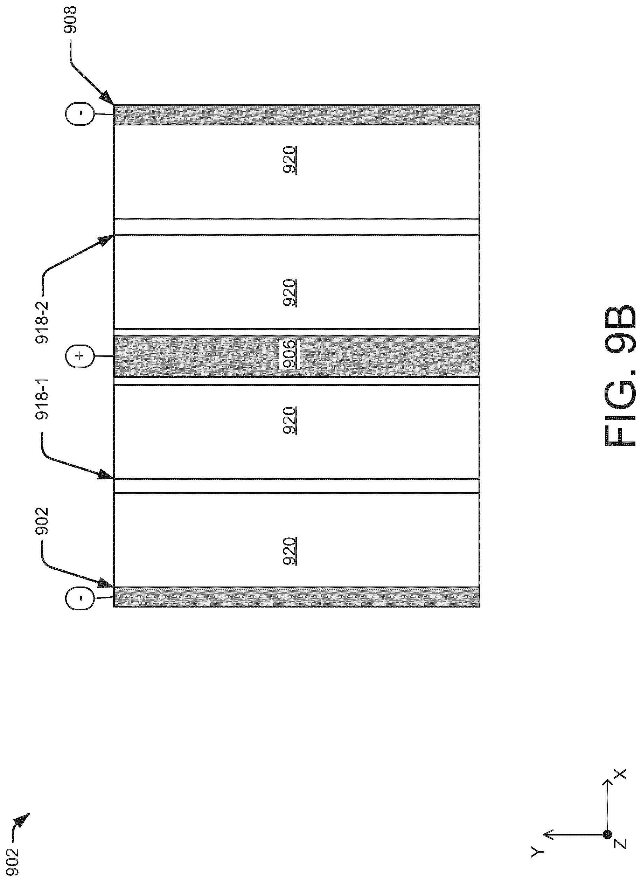

Figure 9A illustrates a schematic side view 900 of a third thin-film photovoltaic module. Figure 9B illustrates a plan view 902 of the third thin-film photovoltaic module illustrated in Figure 9A. Particular thin-film photovoltaic cell examples are described with respect to perovskite photovoltaic cells; however, it is to be appreciated that the particular examples apply to other thin-film photovoltaic cells as well. As shown in the side view 900, the third thin-film photovoltaic module includes the superstrate 704 as well as a first electrode 904, a second electrode 906, and a third electrode 908. First scribe lines P1, second scribe lines P2, third scribe lines P3, and fourth scribe lines P4 of the third thin-film photovoltaic module are illustrated in Figure 9A. In various embodiments, the third thin-film photovoltaic module includes a first contact layer 910 disposed above the superstrate 704, a corresponding absorber layer 914 at least partially disposed above the first contact layer 910, and a second contact layer 916 at least partially disposed above the absorber layer 914. In general, the third thin-film photovoltaic module is similarly configured as the second thin-film photovoltaic module illustrated in Figures 8A-8B but includes a first electrode 904 and a third electrode 906 positioned on the second contact layer 916.

In some embodiments, the second electrode 906 is a common electrode to the first electrode 904 and the third electrode 908. In one or more embodiments, the second electrode 906 is a positive electrode and the first and third electrodes 904, 908 are negative electrodes. As shown, the second electrode 906 is disposed on the first contact layer 910. In some embodiments, in order to improve a geometric fill factor for the third thin-film photovoltaic module, the first and third electrodes 904, 908 may be disposed on the second contact layer 916. In one or more embodiments, the first, second, and third electrodes 904, 906, 908 include the first, second, and third shaped electrodes 804, 806, 808, respectively. In certain embodiments, the third thin-film photovoltaic module may include one or more modifications (e.g., heat sinks) for thermal compensation of including the first and third electrodes 904, 908 on the second contact layer 916. In various embodiments, the third thin-film photovoltaic module can include one or more modifications to compensate for including the first and third electrodes 904, 908 on the second contact layer 916. Examples of such modifications may include additional encapsulation, additional framing, adding coatings or laminates, or other mechanical compensations.

As illustrated in Figure 9B, the third thin-film photovoltaic module includes scribed regions 918-1, 918-2 and photovoltaic cells 920. In some embodiments, a relative order of scribe lines in the scribed regions 918-1 (e.g., P3, P2, P1) is different than a relative order of scribe lines in the scribed regions 918-2 (e.g., P1, P2, P3). For instance, the different relative order of scribe lines in the scribed regions 918-1, 918-2 facilitates elimination of an electrode in the third thin-film photovoltaic module that improves the geometric fill factor for the third thin-film photovoltaic module. In one or more embodiments, the geometric fill factor is further improved by including the first and third electrodes 904, 908 on the second contact layer 916.

### Photovoltaic Module Interconnection Examples

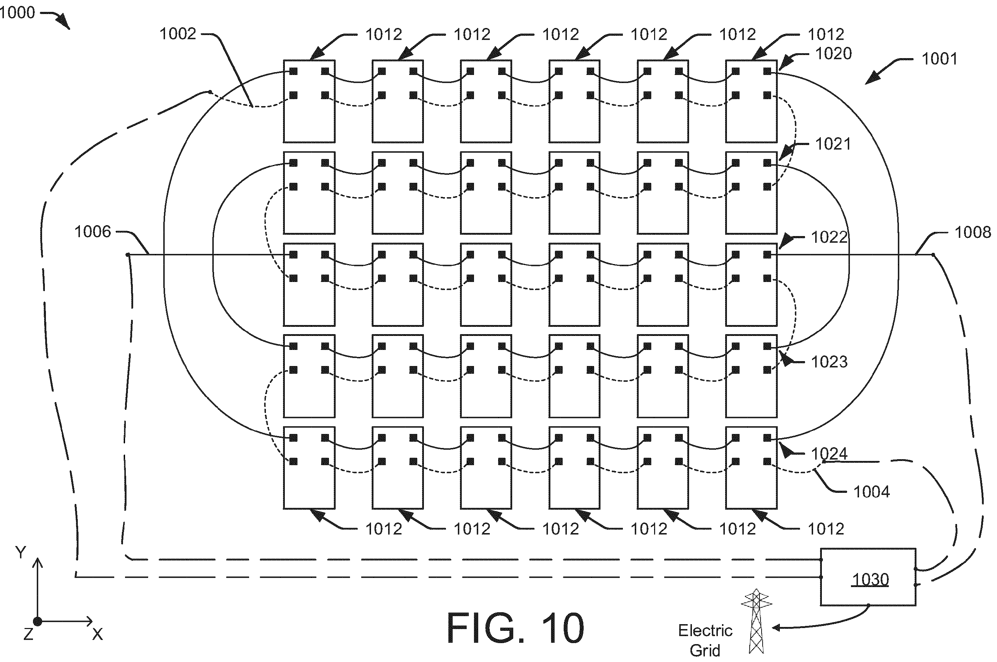

Figure 10 illustrates an example 1000 that includes a system 1001 that includes a combination of photovoltaic modules and thin-film photovoltaic modules separately connected in parallel at a string level. Particular thin-film photovoltaic cell examples are described with respect to perovskite photovoltaic cells. However, it is to be appreciated that the particular examples apply to other thin-film photovoltaic cells as well. As shown in Figure 10, the system 1001 includes a plurality of module pairs 1012 that each include a first module that includes series connected perovskite photovoltaic cells that are positioned over a second module that includes series connected photovoltaic cells (e.g., an array of silicon solar cells). In the example 1000, the inherent mismatches between the perovskite photovoltaic cells and the photovoltaic cells described above can be solved at the string level as opposed to at a module level. Unlike the examples described with respect to Figures 2A, 2B, 3A, 3B, 4A, 4B, 5A, 5B, 6A, and 6B in which the photovoltaic cells and the perovskite photovoltaic cells are included in a single circuit, in the example 1000, the photovoltaic modules are included in a first circuit and the perovskite photovoltaic modules are included in a second circuit. For example, the second circuit is electrically isolated from the first circuit. Since the photovoltaic modules and the perovskite photovoltaic modules are included in separate circuits, it is not necessary to match currents and/or voltages of the separate circuits between the separate circuits. Instead, current/voltage matching for the photovoltaic modules included in the first circuit is performed at the string level using a first power generation parameter matching module (not shown) and current/voltage matching for the perovskite photovoltaic modules included in the second circuit is performed at the string level using a second power generation parameter matching module (not shown). The first power generation parameter matching module is configured to match (e.g., independently from the second power generation parameter matching module) a current and/or a voltage for the photovoltaic modules included in the first circuit. The second power generation parameter matching module is configured to match (e.g., independently from the first power generation parameter matching module) a current and/or a voltage for the perovskite photovoltaic modules included in the second circuit. For example, the first power generation matching module is configured to match a first power generation parameter for the first circuit and the second power generation matching module is configured to match a second power generation parameter for the second circuit. In one or more embodiments, the first power generation parameter is a different type of parameter than the second power generation parameter. In other embodiments, the first power generation parameter is a same type of parameter as the second power generation parameter but the first power generation parameter and the second power generation parameter differ by more than three percent, more than five percent, more than 10 percent, etc. In some embodiments, including the photovoltaic modules and the perovskite photovoltaic modules in separate circuits may improve (reduce) a levelized cost of electricity generation by avoiding the challenges of matching current/voltage given the differences in behaviors of the photovoltaic cells and the perovskite photovoltaic cells. As shown, the example 1000 includes 30 panels (modules) that are wired in series between a positive photovoltaic node 1002 and a negative photovoltaic node 1004, wherein each of the 30 panels includes a plurality of photovoltaic cells that are wired in series. As further shown, the perovskite photovoltaic modules are wired into five parallel strings or subsets 1020-1024 of series connections with the subsets 1020-1024 connected in parallel between a positive perovskite photovoltaic node 1006 and a negative perovskite photovoltaic node 1008. Instead of matching current/voltage between the 30 photovoltaic modules connected in series and the five strings of the perovskite photovoltaic modules connected in parallel, the current/voltage is matched at the string level for the 30 photovoltaic modules connected in series and the current/voltage is matched at the string level for the five strings of the perovskite photovoltaic modules connected in parallel. For example, a device may include a circuit electrically connecting subsets of photovoltaic modules in series and electrically connecting the subsets in parallel. Notably, in some embodiments, a first current through the 30 photovoltaic modules connected in series does not match a second current that is the sum a current through each of the five strings of the perovskite photovoltaic modules connected in parallel. For example, the first current and the second current differ by more than three percent, more than five percent, more than 10 percent, etc. In some embodiments, a first voltage across the 30 photovoltaic modules connected in series does not match a second voltage across each of the five strings of the perovskite photovoltaic modules connected in parallel. In one or more examples, the first voltage and the second voltage differ by more than three percent, more than five percent, more than 10 percent, etc.

As shown in Figure 10, an inverter 1030 is available for receiving power generated by the photovoltaic modules and the perovskite photovoltaic modules. In the illustrated example, the inverter 1030 is electrically coupled to the positive photovoltaic node 1002 and the positive perovskite photovoltaic node 1006 and also electrically coupled to the negative photovoltaic node 1004 and the negative perovskite photovoltaic node 1008. The inverter 1030 is illustrated to be connected to a grid which consumes the power generated by the photovoltaic modules and the perovskite photovoltaic modules. It is to be appreciated that the inverter 1030 can be representative as one inverter or many inverters.

As described above, the photovoltaic modules are included in the first circuit and the perovskite photovoltaic modules are included in the second circuit. In one or more embodiments, the first circuit includes a first plurality of the photovoltaic modules. The first plurality of the photovoltaic modules can be connected in series. The photovoltaic modules include a plurality of first photovoltaic cells that comprise an absorber layer having a first material with a first optical bandgap. In various embodiments, the second circuit includes a second plurality of the perovskite photovoltaic modules. The second plurality of the perovskite photovoltaic modules may be connected in series. The perovskite photovoltaic modules include a plurality of second photovoltaic cells that comprise an absorber layer having a second material with a second optical bandgap that is greater than the first optical bandgap. As described above, during operation, a photovoltaic module of the photovoltaic modules is positioned to receive electromagnetic radiation transmitted through a perovskite photovoltaic module of the perovskite photovoltaic modules.

In one or more embodiments, a parallel circuit is formed by connecting the first circuit and the second circuit in parallel. In some embodiments, photovoltaic cells of the photovoltaic modules each have a first operating voltage during operation. Perovskite photovoltaic cells of the perovskite photovoltaic modules each have a second operating voltage during operation. A first number of photovoltaic cells are included in the first plurality of the photovoltaic modules and a second number of perovskite photovoltaic cells are included in the second plurality of the perovskite photovoltaic modules. In certain embodiments, an operating voltage of the parallel circuit is based on a least common multiple (LCM) of the first number and the second number. For example, the LCM can be less than or equal to 50 such as less than or equal to 40, 25, 10, etc. In some examples, the LCM may be greater than 50.

During operation, a power generation parameter for the first circuit such as a first operating voltage generated by the first circuit is different from a power generation parameter for the second circuit such as a second operating voltage generated by the second circuit. For example, the power generation parameter for the first circuit and the power generation parameter for the second circuit are less than a maximum power generation parameter (e.g., a maximum operating voltage) for the inverter 1030. In some embodiments, the power generation parameter for the first circuit is within about 5 percent of the power generation parameter for the second circuit. In one or more examples, a first voltage across the first circuit is within about 5 percent of a second voltage across the second circuit (e.g., the first voltage is within about 1 percent of the second voltage). In other examples, a first current through the first circuit is within about 5 percent of a second current through the second circuit (e.g., the first current is within about 1 percent of the second current). In some embodiments, a first open circuit voltage across the first circuit (e.g., across the photovoltaic modules) and a second open circuit voltage across the second circuit (e.g., across the perovskite photovoltaic modules) are less than a maximum voltage of an inverter electrically coupled to a photovoltaic device or assembly having the first circuit and the second circuit. In one or more embodiments, the first open circuit voltage of the first circuit is within about 5 percent of the second open circuit voltage of the second circuit (e.g., the first open circuit voltage is within about 1 percent of the second open circuit voltage).

In some embodiments, a first circuit includes thin-film photovoltaic modules connected in parallel (e.g., as parallel strings) such that each parallel connection includes a first number of thin-film photovoltaic modules connected in series. A second circuit can include photovoltaic modules connected in series such that the second circuit includes a second number of photovoltaic modules. In various embodiments, a parallel circuit may be formed by connecting the first circuit in parallel with the second circuit. In some examples, an operating voltage of the parallel circuit is based on a LCM of the first number and the second number. The LCM of the first number and the second number may be less than or equal to 50. In one or more embodiments, the first circuit generates a first operating voltage and the second circuit generates a second operating voltage. The first operating voltage and the second operating voltage may differ by less than 5 percent (e.g., less than 1 percent). In certain embodiments, the inverter 1030 has a voltage rating that is greater than the first operating voltage generated by the first circuit and the second operating voltage generated by the second circuit.

In some embodiments, a group of M series connected photovoltaic modules is included in a first circuit where M is an integer. In one or more examples, M may be greater than 5, greater than 25, greater than 40, greater than 50, or greater than 100. In various embodiments, sets of P series connected thin-film photovoltaic modules included in a second circuit can be electrically connected in parallel with the M series connected photovoltaic modules, where M and P are both integers. In one or more examples, P may be greater than 5, greater than 25, greater than 40, greater than 50, or greater than 100. In the example described above, M is 30 and P is 6. In various embodiments, the operating voltage of M photovoltaic modules and the operating voltage of P thin-film photovoltaic modules have a LCM value. In one example, if each of M photovoltaic modules have an operating voltage of 60 volts and each of the P thin-film photovoltaic modules have an operating voltage of 90 volts, then the parallel connected operating voltage LCM would be 180 volts, which would require the use of a first string of 3 connected photovoltaic modules and a second string of 2 series connected thin-film modules to be placed in parallel. Notably, the operating voltage LCM can be computed for groups/sets of series connected modules versus individual modules in the same manner. In some embodiments, M and P have a LCM and at least one of M or P is equal to the LCM. In this case, if each of the M photovoltaic modules have an operating voltage of 6 volts and each of the P thin-film photovoltaic modules have an operating voltage of 30 volts, then the parallel connected operating voltage LCM would be 30 volts, which would require the use of a first string of 5 series connected M photovoltaic modules and a second string of a single P thin-film photovoltaic module to be placed in parallel. In general, an operating voltage of a particular circuit may be based on a LCM of a number of first photovoltaic modules included in one module included in the particular circuit and a number of second photovoltaic modules includes in another module included in the particular circuit.

In some embodiments, a characteristic of one or more of the at least two different types of devices (e.g., photovoltaic modules and thin-film photovoltaic modules) are adjusted to assure that a total operating voltage LCM can be achieved by the parallel combination of a series connected string of each of the two different types of devices. In one example, the physical dimensions (e.g., exposed surface area (e.g., area formed within the X-Y plane in Figures 7A-7B)) of an electromagnetic radiation collecting region of one of the two different types of devices is adjusted to assure that a LCM of the operating voltage can be achieved in a reasonable number of series connected devices. In some embodiments, the characteristic that is adjusted for at least one of the two different types of devices, such as a thin-film photovoltaic device (e.g., perovskite containing module), is the spacing between scribe lines to adjust the operating voltage or current. For example, referring to Figures 7A-7B, in some embodiments, the lateral spacing (e.g., spacing in the -X-direction and/or +X-direction) between the P1 scribe lines and P2 scribe lines, the P2 scribe lines and P3 scribe lines, or the P1 scribe lines, P2 scribe lines, and P3 scribe lines is adjusted to achieve a desired operating voltage and/or current. In some embodiments, the number of modules that are formed within the photovoltaic device (e.g., perovskite photovoltaic modules) that are connected in series can be increased or decreased to achieve a desired operating voltage LCM. In one example, the number of modules that are formed within a perovskite device is increased by adjusting the scribing pattern of perovskite containing layer stack to include at least one more set of P1 scribe lines, P2 scribe lines, and P3 scribe lines than an initial scribing pattern.

In some embodiments, the characteristic of one or more of the at least two different types of devices is selected so that the total operating voltage of the combination of the two different types of devices required to achieve the operating voltage LCM does not exceed a maximum voltage rating (e.g., voltage rating of the inverter 1030). In some cases, the techniques and systems described above for voltage or current matching of the photovoltaic modules and the perovskite photovoltaic modules may also be applied to avoid exceeding the maximum voltage rating. For example, sizes (dimensions) of the photovoltaic cells/modules and/or the perovskite photovoltaic cells/modules can be increased or decreased and spacing (e.g., scribe spacing) between the photovoltaic cells/modules and the perovskite photovoltaic cells/modules can be increased or decreased to achieve an operating voltage LCM that does not exceed the maximum voltage rating. Additionally, a number of the photovoltaic cells/modules can be increased or decreased and a number of the perovskite photovoltaic cells/modules can also be increased or decreased to achieve the operating voltage LCM that does not exceed the maximum voltage rating.

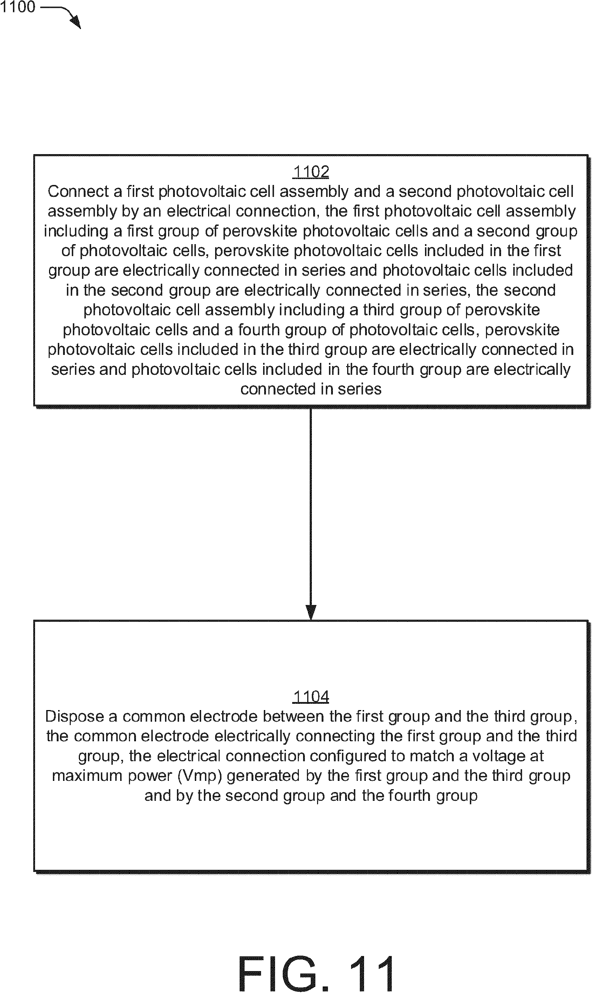

Figure 11 is a flow diagram illustrating a method 1100 for matching a voltage at maximum power (Vmp). At operation 1102, a first photovoltaic module and a second photovoltaic module are connected by an electrical connection, the first photovoltaic module including a first group of thin-film photovoltaic cells and a second group of photovoltaic cells, thin-film photovoltaic cells included in the first group are electrically connected in series and photovoltaic cells included in the second group are electrically connected in series, the second photovoltaic module including a third group of thin-film photovoltaic cells and a fourth group of photovoltaic cells, thin-film photovoltaic cells included in the third group are electrically connected in series and photovoltaic cells included in the fourth group are electrically connected in series. At 1104, a common electrode is disposed between the first group and the third group, the common electrode electrically connecting the first group and the third group, the electrical connection configured to match a voltage at maximum power (Vmp) generated by the first group and the third group and by the second group and the fourth group.

### REPRESENTATIVE FEATURES

Representative features are set out in the following clauses, which stand alone or may be combined, in any combination, with one or more features disclosed in the text and/or drawings of the specification.
1. A photovoltaic device, comprising:
   a first photovoltaic cell assembly including a first group of thin-film photovoltaic cells and a second group of photovoltaic cells, thin-film photovoltaic cells included in the first group are electrically connected in series and photovoltaic cells included in the second group are electrically connected in series;
   a second photovoltaic cell assembly including a third group of thin-film photovoltaic cells and a fourth group of photovoltaic cells, thin-film photovoltaic cells included in the third group are electrically connected in series and photovoltaic cells included in the fourth group are electrically connected in series;
   a common electrode; and
   an electrical connection of the first photovoltaic cell assembly and the second photovoltaic cell assembly, the electrical connection configured to match a voltage at maximum power (Vmp) generated by the first group and the third group and by the second group and the fourth group, wherein the common electrode is electrically connected to:
      an anode end of the first photovoltaic cell assembly; and
      an anode end of the second photovoltaic cell assembly.
2. The photovoltaic device of clause 1, wherein the first photovoltaic cell assembly and the second photovoltaic cell assembly are electrically connected in parallel.
3. The photovoltaic device of clause 2, wherein the common electrode is common to a first electrode that is coupled to a cathode end of the first photovoltaic cell assembly and a second electrode that is coupled to a cathode end of the second photovoltaic cell assembly.
4. The photovoltaic device of clause 1, wherein the thin-film photovoltaic cells included in the first group are positioned between the photovoltaic cells included in the second group and a source of electromagnetic radiation when power is being generated by the photovoltaic device.
5. The photovoltaic device of clause 4, wherein photons received by the photovoltaic cells included in the second group are transmitted through the thin-film photovoltaic cells included in the first group.
6. The photovoltaic device of clause 4, wherein the thin-film photovoltaic cells included in the first group include a first material having a first optical bandgap and the photovoltaic cells included in the second group include a second material having a second optical bandgap that is less than the first optical bandgap.
7. The photovoltaic device of clause 6, wherein the first material includes a perovskite.
8. The photovoltaic device of clause 1, wherein the Vmp is less than 100 volts at nominal operating cell temperature (NOCT).
9. A photovoltaic device assembly, comprising:
   a first set of cells including first groups of thin-film photovoltaic cells electrically connected in a first series and second groups of photovoltaic cells electrically connected in a second series, the first series is electrically connected in parallel with the second series in the first set of cells;
   a second set of cells including third groups of thin-film photovoltaic cells electrically connected in a third series and fourth groups of photovoltaic cells electrically connected in a fourth series, the third series is electrically connected in parallel with the fourth series in the second set of cells; and
   an anode that is common to the first set of cells and the second set of cells, the anode disposed between a first cathode and a second cathode, wherein the anode, the first cathode, and the second cathode include electrical connections that electrically connect the first set of cells in parallel with the second set of cells, and wherein the electrical connections are configured to match a voltage at maximum power (Vmp) generated by the first set of cells and the second set of cells.
10. The photovoltaic device assembly of clause 9, further comprising a third set of cells including fifth groups of thin-film photovoltaic cells electrically connected in a fifth series and sixth groups of thin-film photovoltaic cells electrically connected in a sixth series, the fifth series is electrically connected in parallel with the sixth series in the third set of cells.
11. The photovoltaic device assembly of clause 10, wherein the electrical connections electrically connect the third set of cells in parallel with the first set of cells and in parallel with the second set of cells, and wherein the electrical connections are configured to match the Vmp generated by the first set of cells, the second set of cells, and the third set of cells.
12. The photovoltaic device assembly of clause 10, wherein the third set of cells includes a seventh group of thin-film photovoltaic cells electrically connected in a seventh series, and wherein the seventh series is electrically connected in parallel with the fifth series and in parallel with the sixth series.
13. The photovoltaic device assembly of clause 9, wherein the Vmp is less than 100 volts at nominal operating cell temperature (NOCT).
14. The photovoltaic device assembly of clause 9, wherein the first groups of thin-film photovoltaic cells electrically connected in the first series include a first material having a first optical bandgap and the second groups of photovoltaic cells electrically connected in the second series include a second material having a second optical bandgap that is less than the first optical bandgap.
15. The photovoltaic device assembly of clause 14, wherein the first material includes a perovskite.
16. A photovoltaic device assembly, comprising:
   thin-film photovoltaic cells having corresponding absorber layers that include a first material;
   photovoltaic cells disposed below the thin-film photovoltaic cells wherein a photovoltaic cell of the photovoltaic cells is positioned to receive electromagnetic radiation transmitted through a thin-film photovoltaic cell of the thin-film photovoltaic cells, the photovoltaic cells having corresponding absorber layers that include a second material; and
   an electrical conductor disposed between the thin-film photovoltaic cells and the photovoltaic cells, the electrical conductor forming a first electrical path between an anode end of the thin-film photovoltaic cells and an anode end of the photovoltaic cells and a second electrical path between a cathode end of the thin-film photovoltaic cells and a cathode end of the photovoltaic cells, the first electrical path and the second electrical path are configured to match a voltage generated at nominal operating cell temperature (NOCT) by the thin-film photovoltaic cells and by the photovoltaic cells.
17. The photovoltaic device assembly of clause 16, wherein the voltage generated at NOCT is less than 100 volts.
18. The photovoltaic device assembly of clause 16, wherein the first material has a first optical bandgap in a range of 1.4 to 1.8 eV and the second material has a second optical bandgap that is less than the first optical bandgap.
19. The photovoltaic device assembly of clause 16, wherein the first material includes a perovskite and the second material includes silicon.
20. The photovoltaic device assembly of clause 16, wherein the electrical conductor includes an anodic electrode between a first cathodic electrode of a first set of the thin-film photovoltaic cells and a second cathodic electrode of a second set of the thin-film photovoltaic cells.
21. The photovoltaic device assembly of clause 20, wherein the anodic electrode includes a flat ribbon that is disposed on a first contact layer and between the absorber layers that include the first material and a second contact layer.
22. The photovoltaic device assembly of clause 20, wherein the anodic electrode includes a wire having a first cross-sectional shape that is at least one of circular, triangular, or hemispherical and the first cathodic electrode includes a wire having a second cross-sectional shape that is different from the first cross-sectional shape.
23. The photovoltaic device assembly of clause 20, wherein the first set of the thin-film photovoltaic cells are electrically connected in parallel with the second set of the thin-film photovoltaic cells.
24. The photovoltaic device assembly of clause 23, wherein the photovoltaic cells are electrically connected in series.
25. A photovoltaic device, comprising:
   sets of series connected first photovoltaic cells having corresponding absorber layers that include a first material, the sets of the series connected first photovoltaic cells are electrically connected in parallel;
   series connected second photovoltaic cells disposed below the first photovoltaic cells wherein a second photovoltaic cell of the second photovoltaic cells is positioned to receive electromagnetic radiation transmitted through a first photovoltaic cell of the first photovoltaic cells, the second photovoltaic cells having corresponding absorber layers that include a second material; and
   an electrical conductor disposed between the first photovoltaic cells and the second photovoltaic cells, the electrical conductor forming a first electrical path between an anode end of the first photovoltaic cells and an anode end of the second photovoltaic cells and a second electrical path between a cathode end of the first photovoltaic cells and a cathode end of the second photovoltaic cells, the first electrical path and the second electrical path are configured to match a voltage generated at nominal operating cell temperature (NOCT) by the first photovoltaic cells and by the second photovoltaic cells.
26. The photovoltaic device of clause 25, wherein the electrical conductor includes an anodic electrode between a first cathodic electrode of a first set of the first photovoltaic cells and a second cathodic electrode of a second set of the first photovoltaic cells.
27. The photovoltaic device of clause 26, wherein the anodic electrode includes a wire having a first cross-sectional shape that is at least one of circular, triangular, or hemispherical and the first cathodic electrode includes a wire having a second cross-sectional shape that is different from the first cross-sectional shape.
28. The photovoltaic device of clause 25, wherein the voltage generated at NOCT is less than 100 volts.
29. The photovoltaic device of clause 25, wherein the first material has a first optical bandgap in a range of 1.4 to 1.8 eV and the second material has a second optical bandgap that is less than the first optical bandgap.
When used in this specification and claims, the terms "comprises" and "comprising" and variations thereof mean that the specified features, steps or integers are included. The terms are not to be interpreted to exclude the presence of other features, steps or components.
While the foregoing is directed to embodiments of the present disclosure, other and further embodiments of the disclosure may be devised without departing from the basic scope thereof, and the scope thereof is determined by the claims that follow.

## Claims

1. A photovoltaic device, comprising:
a first photovoltaic cell assembly including a first group of thin-film photovoltaic cells and a second group of photovoltaic cells, thin-film photovoltaic cells included in the first group are electrically connected in series and photovoltaic cells included in the second group are electrically connected in series;
a second photovoltaic cell assembly including a third group of thin-film photovoltaic cells and a fourth group of photovoltaic cells, thin-film photovoltaic cells included in the third group are electrically connected in series and photovoltaic cells included in the fourth group are electrically connected in series;
a common electrode; and
an electrical connection of the first photovoltaic cell assembly and the second photovoltaic cell assembly, the electrical connection configured to match a voltage at maximum power (Vmp) generated by the first group and the third group and by the second group and the fourth group, wherein the common electrode is electrically connected to:
an anode end of the first photovoltaic cell assembly; and
an anode end of the second photovoltaic cell assembly.

2. The photovoltaic device of claim 1, wherein the first photovoltaic cell assembly and the second photovoltaic cell assembly are electrically connected in parallel.

3. The photovoltaic device of claim 2, wherein the common electrode is common to a first electrode that is coupled to a cathode end of the first photovoltaic cell assembly and a second electrode that is coupled to a cathode end of the second photovoltaic cell assembly.

4. The photovoltaic device of any preceding claim, wherein the thin-film photovoltaic cells included in the first group are positioned between the photovoltaic cells included in the second group and a source of electromagnetic radiation when power is being generated by the photovoltaic device.

5. The photovoltaic device of claim 4, wherein photons received by the photovoltaic cells included in the second group are transmitted through the thin-film photovoltaic cells included in the first group.

6. The photovoltaic device of claim **4** or 5, wherein the thin-film photovoltaic cells included in the first group include a first material having a first optical bandgap and the photovoltaic cells included in the second group include a second material having a second optical bandgap that is less than the first optical bandgap; and optionally wherein the first material includes a perovskite.

7. The photovoltaic device of any preceding claim, wherein the Vmp is less than 100 volts at nominal operating cell temperature (NOCT).

8. A photovoltaic device assembly, comprising:
a first set of cells including first groups of thin-film photovoltaic cells electrically connected in a first series and second groups of photovoltaic cells electrically connected in a second series, the first series is electrically connected in parallel with the second series in the first set of cells;
a second set of cells including third groups of thin-film photovoltaic cells electrically connected in a third series and fourth groups of photovoltaic cells electrically connected in a fourth series, the third series is electrically connected in parallel with the fourth series in the second set of cells; and
an anode that is common to the first set of cells and the second set of cells, the anode disposed between a first cathode and a second cathode, wherein the anode, the first cathode, and the second cathode include electrical connections that electrically connect the first set of cells in parallel with the second set of cells, and wherein the electrical connections are configured to match a voltage at maximum power (Vmp) generated by the first set of cells and the second set of cells.

9. The photovoltaic device assembly of claim 8, including one or more of the following:
a) a third set of cells including fifth groups of thin-film photovoltaic cells electrically connected in a fifth series and sixth groups of thin-film photovoltaic cells electrically connected in a sixth series, the fifth series is electrically connected in parallel with the sixth series in the third set of cells; and optionally:
wherein the electrical connections electrically connect the third set of cells in parallel with the first set of cells and in parallel with the second set of cells, and wherein the electrical connections are configured to match the Vmp generated by the first set of cells, the second set of cells, and the third set of cells; and/or
wherein the third set of cells includes a seventh group of thin-film photovoltaic cells electrically connected in a seventh series, and wherein the seventh series is electrically connected in parallel with the fifth series and in parallel with the sixth series;
b) wherein the Vmp is less than 100 volts at nominal operating cell temperature (NOCT); and
c) wherein the first groups of thin-film photovoltaic cells electrically connected in the first series include a first material having a first optical bandgap and the second groups of photovoltaic cells electrically connected in the second series include a second material having a second optical bandgap that is less than the first optical bandgap; and optionally wherein the first material includes a perovskite.

10. A photovoltaic device assembly, comprising:
thin-film photovoltaic cells having corresponding absorber layers that include a first material;
photovoltaic cells disposed below the thin-film photovoltaic cells wherein a photovoltaic cell of the photovoltaic cells is positioned to receive electromagnetic radiation transmitted through a thin-film photovoltaic cell of the thin-film photovoltaic cells, the photovoltaic cells having corresponding absorber layers that include a second material; and
an electrical conductor disposed between the thin-film photovoltaic cells and the photovoltaic cells, the electrical conductor forming a first electrical path between an anode end of the thin-film photovoltaic cells and an anode end of the photovoltaic cells and a second electrical path between a cathode end of the thin-film photovoltaic cells and a cathode end of the photovoltaic cells, the first electrical path and the second electrical path are configured to match a voltage generated at nominal operating cell temperature (NOCT) by the thin-film photovoltaic cells and by the photovoltaic cells.

11. The photovoltaic device assembly of claim 10, including one or more of the following:
a) wherein the voltage generated at NOCT is less than 100 volts;
b) wherein the first material has a first optical bandgap in a range of 1.4 to 1.8 eV and the second material has a second optical bandgap that is less than the first optical bandgap; and
c) wherein the first material includes a perovskite and the second material includes silicon.

12. The photovoltaic device assembly of claim 10 or 11, wherein the electrical conductor includes an anodic electrode between a first cathodic electrode of a first set of the thin-film photovoltaic cells and a second cathodic electrode of a second set of the thin-film photovoltaic cells.

13. The photovoltaic device assembly of claim 12, including one or more of the following;
a) wherein the anodic electrode includes a flat ribbon that is disposed on a first contact layer and between the absorber layers that include the first material and a second contact layer; or
wherein the anodic electrode includes a wire having a first cross-sectional shape that is at least one of circular, triangular, or hemispherical and the first cathodic electrode includes a wire having a second cross-sectional shape that is different from the first cross-sectional shape; and
b) wherein the first set of the thin-film photovoltaic cells are electrically connected in parallel with the second set of the thin-film photovoltaic cells; and optionally wherein the photovoltaic cells are electrically connected in series.

14. A photovoltaic device, comprising:
sets of series connected first photovoltaic cells having corresponding absorber layers that include a first material, the sets of the series connected first photovoltaic cells are electrically connected in parallel;
series connected second photovoltaic cells disposed below the first photovoltaic cells wherein a second photovoltaic cell of the second photovoltaic cells is positioned to receive electromagnetic radiation transmitted through a first photovoltaic cell of the first photovoltaic cells, the second photovoltaic cells having corresponding absorber layers that include a second material; and
an electrical conductor disposed between the first photovoltaic cells and the second photovoltaic cells, the electrical conductor forming a first electrical path between an anode end of the first photovoltaic cells and an anode end of the second photovoltaic cells and a second electrical path between a cathode end of the first photovoltaic cells and a cathode end of the second photovoltaic cells, the first electrical path and the second electrical path are configured to match a voltage generated at nominal operating cell temperature (NOCT) by the first photovoltaic cells and by the second photovoltaic cells.

15. The photovoltaic device of claim 14, including one or more of the following:
a) wherein the electrical conductor includes an anodic electrode between a first cathodic electrode of a first set of the first photovoltaic cells and a second cathodic electrode of a second set of the first photovoltaic cells; and optionally
wherein the anodic electrode includes a wire having a first cross-sectional shape that is at least one of circular, triangular, or hemispherical and the first cathodic electrode includes a wire having a second cross-sectional shape that is different from the first cross-sectional shape;
b) wherein the voltage generated at NOCT is less than 100 volts; and
c) wherein the first material has a first optical bandgap in a range of 1.4 to 1.8 eV and the second material has a second optical bandgap that is less than the first optical bandgap.
